Europäisches Patentamt

European Patent Office

Office européen des brevets

(19)

(11) Veröffentlichungsnummer : **0 252 536 B1**

(12) **EUROPÄISCHE PATENTSCHRIFT**

(45) Veröffentlichungstag der Patentschrift :
27.12.91 Patentblatt 91/52

(21) Anmeldenummer : 87200878.4

(22) Anmeldetag : 13.05.87

(51) Int. Cl.⁵ : **G02B 6/10, G02B 6/12,
H01F 10/24**

(54) **Verfahren zur Herstellung eines optischen Streifenwellenleiters für nicht-reziproke optische Bauelemente.**

(30) Priorität : 12.02.87 DE 3704378
21.05.86 DE 3617060

(43) Veröffentlichungstag der Anmeldung :
13.01.88 Patentblatt 88/02

(45) Bekanntmachung des Hinweises auf die
Patenterteilung :
27.12.91 Patentblatt 91/52

(84) Benannte Vertragsstaaten :
DE FR GB

(56) Entgegenhaltungen :
EP-A- 0 167 213
DE-A- 3 032 608
PATENT ABSTRACTS OF JAPAN, Band 8, Nr.
144 (P-284)[1581], 5. Juli 1984; & JP - A - 59
44004 (MATSUSHITA DENKI) 12.03.1984
IDEM
JOURNAL OF APPLIED PHYSICS, Band 57, Nr.
8, Teil 2B, 1985, Seiten 3885-3887, New York,
US; J.-P. KRUMME et al.: "Bismuth iron garnet
films prepared by rf magnetron sputtering"
IBM TECHNICAL DISCLOSURE BULLETIN,
Band 16, Nr. 9, Februar 1974, Seite 2871; A.K.
GAIND et al.: "Doped polysilicon isolation
process"
PHILIPS TECHNICAL REVIEW, Band 41, Nr. 2,
Seiten 33-45, 1983/84, Eindhoven, NL; P. HAN-
SEN et al.: "Optical switching with bismuth-
substituted iron garnets"
APPLIED PHYSICS, Band 24, Nr. 2, Februar
1981, Seiten 163-167, Heidelberg; D.J. BREED
et al.: "Garnet films for micron and submicron
magnetic-bubbles with low damping constants"
IEEE TRANSACTIONS ON MAGNETICS, Band
MAG-20, Nr. 5, Teil 1, 1984, Seiten 983-985,
New York, US; J.-P. KRUMME et al.:
"Bismuth-substituted iron garnet films prepared by rf diode sputtering"

(56) Entgegenhaltungen :
PATENT ABSTRACTS OF JAPAN, Band 6, Nr.
255 (P-162)[1133], 14. Dezember 1982; & JP - A
- 57 150 804 (NIPPON DENKI K.K.) 17.09.1982
R.G. HUNSPERGER "Integrated Optics: Theory and Technology", 1982, Seiten 38-69,
Springer Verlag, Berlin, Heidelberg, New York;

(73) Patentinhaber : Philips Patentverwaltung
GmbH
Wendenstrasse 35 Postfach 10 51 49
W-2000 Hamburg 1 (DE)
(84) Benannte Vertragsstaaten :DE
Patentinhaber : N.V. Philips'
Gloeilampenfabrieken
Groenewoudseweg 1
NL-5621 BA Eindhoven (NL)
(84) Benannte Vertragsstaaten :FR GB

(72) Erfinder : Doormann, Volker
Borchertring 27
W-2000 Hamburg 60 (DE)
Erfinder : Krumme, Jens-Peter, Dr.
Heydornweg 4
W-2000 Hamburg 55 (DE)

(74) Vertreter : Nehmzow-David, Fritzi-Maria et al
Philips Patentverwaltung GmbH
Wendenstrasse 35 Postfach 10 51 49
W-2000 Hamburg 1 (DE)

Anmerkung : Innerhalb von neun Monaten nach der Bekanntmachung des Hinweises auf die Erteilung
des europäischen Patents kann jedermann beim Europäischen Patentamt gegen das erteilte europäische Patent Einspruch einlegen. Der Einspruch ist schriftlich einzureichen und zu begründen. Er gilt
erst als eingelegt, wenn die Einspruchsgebühr entrichtet worden ist (Art. 99(1) Europäisches Patentübereinkommen).

EP 0 252 536 B1

## Beschreibung

Die Erfindung betrifft ein Verfahren zur Herstellung eines optischen Streifenwellenleiters für nicht-reziproke optische Bauelemente mit einem auf einem einkristallinen Granat-Substrat angebrachten einkristallinen Wellenleiterstreifen aus einem Eisengranat mit einem Brechungsindex $n_2$, der von Material eines niedrigeren Brechungsindex $n_1$ umgeben ist.

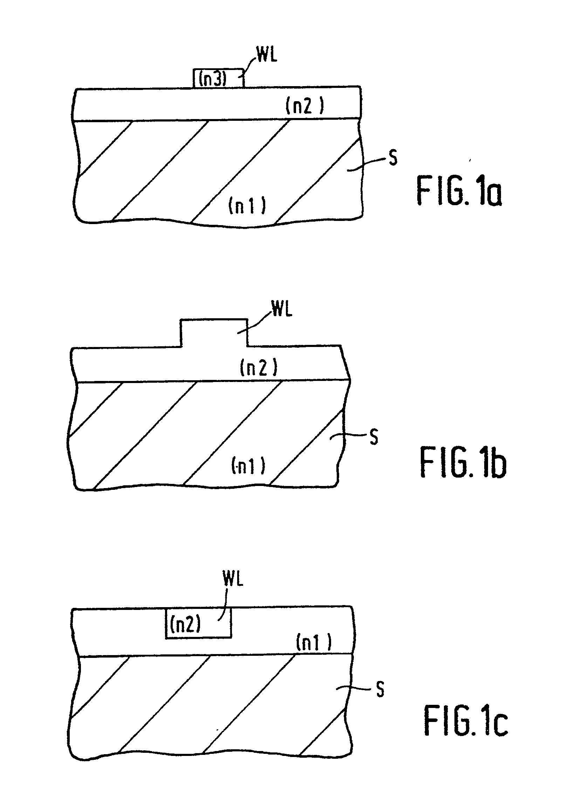

Bei optischen Übertragungsstrecken wird Licht entweder in optischen Wellenleitern in Form von Lichtleitfasern oder aber in schichtförmigen Wellenleitern geführt, die als Streifenwellenleiter ausgebildet sind mit einem Sprung des Brechungsindex zu kleineren Werten in dem die Wellenleiterstreifen umgebenden Material. Hierzu wird verwiesen auf R.G. Hunsperger, "Integrated optics": Theory and Technology, Springer-Verlag, 1982, insbesondere Seiten 38 bis 69. Die schichtförmigen Streifenwellenleiter können als Streifen-geführte Wellenleiter (sogenannte "strip loaded waveguides", Seite 43) (Fig. 1a), Wulstwellenleiter ("ridged waveguides", Seite 66) (Fig. 1b) oder Kanalwellenleiter ("channel waveguides", Seite 38) (Fig. 1c) ausgebildet sein. Diese Ausführungsformen sind u.a. durch die bekannte verfügbare Technologie geprägt.

Das vorliegende Verfahren eignet sich insbesondere zur Herstellung von "ridged waveguides" und "channel waveguides" sowie zur Herstellung von halbabstrahlenden optischen Isolatoren (semi-leaky isolator). Bei Isolatoren mit semi-leaky-Verhalten passiert die Vorwärtswelle des eingestrahlten Lichtes (z.B. TM-Mode) den Isolator ungedämpft, wogegen reflektierte Wellen abgestrahlt werden (Ausbildung von TE-Moden).

Die bekannten Streifenwellenleiter sind mit in der integrierten Optik bisher angewendeten Materialien wie $LiNbO_3$ oder auf Basis von $A^{III}B^V$-Verbindungen realisiert worden. Für insbesondere nicht-reziproke optische Wellenleitung hat sich nun Eisengranat als besonders geeignet erwiesen. Es ist bisher jedoch nicht gelungen, Streifenwellenleiter auf Basis von Eisengranat in für den Anwendungszweck befriedigender Qualität herzustellen.

Planare Wellenleiter aus Eisengranat werden z.B. für die Verwendung als optische Isolatoren in kohärenten Übertragungsnetzen bei Frequenzen von $> 10^2$ MHz diskutiert; hierzu wird verwiesen auf I.E.E.E. J. Quantum Electr. QE-18, 1982, Seite 1975. Ein "channel waveguide" muß folgende Bedingungen erfüllen: für die Wellenleiterstreifen sind Dicken von einigen μm optimal. Um nun Wellenleiterstreifen-Dicken von einigen μm zulassen zu können, muß der Sprung des Brechungsindex $n_2$-$n_1$ zu dem die Wellenleiterstreifen umgebenden Material bei einigen $10^{-3}$ liegen, wenn eine Monomode-Wellenleitung im Streifenwellenleiter erreicht werden soll. Bei einem derart geringen Sprung des Brechungsindex zwischen dem Material des Wellenleiterstreifens ($n_2$) und dem ihn umgebenden Material ($n_1$) leckt die Lichtwelle tief in das umgebende Material ein, so daß für das Erzielen geringer Verluste im Wellenleiterstreifen nicht nur der Wellenleiterstreifen selbst sondern auch das ihn umgebende Material eine sehr geringe intrinsische Absorption $\alpha$ und Lichtstreuung aufweisen müssen ( $< 1$ dB/cm).

Aus JP-A 57-150 840 war ein Verfahren zur Herstellung eines optischen Streifenwellenleiters mit einem auf einem einkristallinen Gadolinium-Gallium-Granat-Substrat mittels Flüssigphasenepitaxie angebrachten einkristallinen Eisengranat-Wellenleiterstreifen bekannt.

Mit diesem bekannten Verfahren sind die Nachteile verbunden, daß Granatschichten in auch Nicht-Gleichgewichtszusammensetzungen ohne Fremdphase nicht hergestellt werden können und der Fertigungsprozeß für diese bekannten Streifenwellenleiter außerdem relativ aufwendig ist, weil infolge der Anwendung eines Flüssigphasenepitaxie-Prozesses für die Herstellung der Wellenleiterstreifen die Vorbereitung der Substrate für die nachfolgende Beschichtung und die Abscheidung der Wellenleiterstreifen in getrennten Vorrichtungen erfolgen müssen. Ein weiterer Nachteil dieses bekannten Verfahrens ist, daß keine homogenen dünnen Wellenleiter-Schichten hergestellt werden können, weil bei Anwendung von Flüssigphasenepitaxie immer Übergangsschichten entstehen. Überdies ergeben sich für die Fertigung von optischen Streifenwellenleitern nach dem bekannten Verfahren gewisse Schwierigkeiten bei der Auswahl des Substrat-materials hinsichtlich der Anpassung der Gitterkonstanten von Substrat und Schicht; Gitterfehlanpassungen von $> 1\%$ führen zu nicht einwandfrei epitaktisch aufwachsenden Schichten, wenn für die Herstellung der einkristallinen Schichten ein Flüssigphasenepitaxieprozeß eingesetzt wird.

Der Erfindung liegt die Aufgabe zugrunde, ein Verfahren anzugeben, mit dem Streifenwellenleiter und insbesondere halbabstrahlende optische Isolatoren auf Basis von Eisengranat hergestellt werden können, die geringe Werte für intrinsische Absorption $\alpha$ und einstellbare Werte für den Brechungsindexsprung $n_2$-$n_1$ bei geringen sonstigen Verlusten aufweisen.

Diese Aufgabe wird erfindungsgemäß dadurch gelöst, daß das Kristallgitter des Substrats örtlich in den Oberflächenbereichen, auf denen kein Wellenleiterstreifen aufwachsen soll, unter Ausbildung von Gitterfehlordnungen gestört wird und daß der Wellenleiterstreifen und das ihn umgebende Material mittels HF-Kathodenzerstäubung (Sputter-epitaxie) in einem Inertgasplasma unter Verwendung eines überwiegend eine Eisengranatphase enthaltenden Targets mit anderen Phasen nahezu gleicher Zerstäubungsrate auf dem Sub-

2

strat abgeschieden wird, wobei die Kathodenzerstäubung in der Weise durchgeführt wird, daß nur in den ungestörten Oberflächenbereichen eine einkristalline Struktur erhalten wird.

Der Erfindung liegt die Erkenntnis zugrunde, daß Sputter-epitaxie von z.B. komplex zusammengesetzten Schichten, die aus Elementen sehr voneinander abweichender Zerstäubungsrate bestehen, realisiert werden kann, wenn einkristalline Substrate mit gut definierten, ungestörten Oberflächen und wenn Targets mit Phasen nahezu gleicher Zerstäubungsrate eingesetzt werden und wenn der HF-Kathodenzerstäubungsprozeß in einem Inertgasplasma, vorzugsweise einem Edelgasplasma, unter Einsatz vorzugsweise einer Magnetronelektrode durchgeführt wird.

Nach weiteren vorteilhaften Ausgestaltungen des Verfahrens gemäß der Erfindung wird als Substrat eine in (111)-Richtung orientierte nicht-magnetische Granat-Einkristallscheibe eingesetzt oder es wird als Substrat eine in (110)-Richtung orientierte nicht-magnetische Granat-Einkristallscheibe eingesetzt; vorzugsweise bestehen die Einkristallscheiben aus Calcium-Magnesium-Zirkonium-substituiertem Gadolinium-Gallium-Granat $(Gd,Ca)_3(Ga,Mg,Zr)_5O_{12}$.

Es können jedoch auch ebensogut andere nicht-magnetische Gallium-Granat-Substrate eingesetzt werden. Insbesondere mit der Verwendung einer in (110)-Richtung orientierten Granat-Einkristallscheibe ist die Möglichkeit verbunden, einen optischen Isolator mit einer spannungsinduzierten optischen Doppelbrechung in der Schichtebene herzustellen. Mittels Röntgen-Doppel-Kristall-Rocking-Kurven wurde gefunden, daß die auf einem derartigen Substrat abgeschiedenen einkristallinen Schichten eine gute Röntgenlinienbreite aufweisen, auch wenn eine hohe Kristallgitterfehlanpassung (misfit) von etwa 1% zwischen Substrat und abgeschiedener einkristalliner Schicht vorliegt, was für Isolatoren mit semi-leaky-Eigenschaften interessant ist.

Nach einer vorteilhaften weiteren Ausbildung des Verfahrens nach der Erfindung hat der einkristalline Wellenleiterstreifen und ihn umgebendes Material eine Zusammensetzung gemäß der allgemeinen Formel $(A,B)_3(A,B)_5O_{12}$ mit A = mindestens ein Seltenerdmetall, Bi,Pb und/oder Ca und B = Ga,Al,Fe,Co,Ni,Mn,Ru,Ir,In und/oder Sc.

Da der Sputterepitaxieprozeß im Gegensatz zu z.B. Flüssigphasenepitaxieprozessen entfernt vom thermo-chemischen Gleichgewicht verläuft, ist auch die Herstellung von z.B. Granatschichten in Nicht-Gleichgewichtszusammensetzungen ohne Fremdphase möglich.

Es wurde z.B. einphasiges Eisengranatmaterial in Form von einkristallinen Wellenleiterstreifen und sie umgebendes Material anderer Ordnung (amorph oder polykristallin) mit folgenden Zusammensetzungen hergestellt:

1. $Gd_{1,90}Bi_{1,45}Fe_{4,09}Al_{0,34}Ga_{0,22}O_{12}$

2. $Gd_{1,97}Bi_{1,04}Fe_{4,51}Ga_{0,22},Al_{0,26}O_{12}$.

Nach weiteren vorteilhaften Ausgestaltungen des erfindungsgemäßen Verfahrens ist das den Wellenleiterstreifen seitlich umgebende Material amorph oder es ist polykristallin. Polykristallines Material ist dann zu bevorzugen, wenn kleine Absorptionen verlangt werden.

Nach vorteilhaften Weiterbildungen des Verfahrens gemäß der Erfindung wird das Substrat während des Epitaxieprozesses auf eine Temperatur aufgeheizt, die höher ist, als die Temperatur, bei der epitaxiales Wachstum auf Substratbereichen mit ungestörtem Kristallgitter beginnt, und die niedriger ist, als die Temperatur, bei der polykristallines Wachstum auf Substratbereichen mit gestörtem Kristallgitter beginnt; vorzugsweise wird das Substrat auf eine Temperatur im Bereich von 450 bis 520 °C aufgeheizt.

Nach einer weiteren vorteilhaften Ausgestaltung des erfindungsgemäßen Verfahrens wird das Substrat während des Epitaxieprozesses auf eine Temperatur aufgeheizt, die höher ist als die Temperatur, bei der polykristallines Wachstum auf Substratbereichen mit gestörtem Kristallgitter beginnt; vorzugsweise wird das Substrat auf eine Temperatur > 520 °C aufgeheizt.

Bei Temperaturen oberhalb von 450 °C ergibt sich die Möglichkeit, auf einem in seiner Gitterstruktur örtlich gestörten einkristallinen Granatsubstrat eine Schicht abzuscheiden, die aus Bereichen unterschiedlicher Ordnung, nämlich amorphen oder polykristallinen Schichtbereichen neben einkristallinen Granatschichtbereichen besteht. Die zu wählende Substrattemperatur ist dabei abhängig von der gewünschten Zusammensetzung der herzustellenden Schicht sowie von ihrer Ordnung und muß empirisch ermittelt werden.

Bei einem Sputterepitaxieprozeß spielt die Temperatur des Substrates während des Abscheidungsprozesses folgende Rolle: eine höhere Substrattemperatur begünstigt eine spontane Kristallisation der abgeschiedenen Schicht, wobei nun gefunden wurde, daß epitaxiales Wachstum auf Substratbereichen mit ungestörtem Kristallgitter bei niedrigeren Temperaturen einsetzt, als polykristallines Wachstum auf Substratbereichen mit gestörtem Kristallgitter.

Das bedeutet also, daß $T_{epitaktisches\ Wachstum} < T_{polykristallines\ Wachstum}$ ist.

Diese Temperaturen werden im folgenden als $T_{epi}$ bzw. $T_{poly}$ bezeichnet. Werden Substrate eingesetzt, deren Kristallgitter an der Oberfläche örtlich, z.B. durch Ionenbeschuß, in einen Fehlordnungszustand überführt wurden, wird auf den gestörten Substratbereichen je nach Höhe der Substrattemperatur eine amorphe oder eine polykristalline Schicht durch den Kathodenzerstäubungsprozeß abgeschieden, wogegen auf den ungestörten, einkristallinen Bereichen das durch Kathodenzerstäubung abgeschiedene Material einkristallin aufwächst. Für die zu wählende Substrattemperatur T bei der Herstellung einer strukturierten Schicht mit einkristallinen und benachbarten amorphen Schichtbereichen mittels Sputterepitaxie gilt: $T_{epi} < T_{substrat} < T_{poly}$.

Für die zu wählende Substrattemperatur T bei der Herstellung von einkristallinen Wellenleiterstreifen mit benachbartem polykristallinem Material gilt: $T_{substrat} > T_{poly}$.

Wird das Substrat auf eine Temperatur erhitzt, die unterhalb der Temperatur liegt, bei der epitaxiales Wachstum einsetzt, werden nur amorphe Schichten abgeschieden, unabhängig davon, ob das Substrat ein gestörtes oder ein ungestörtes Kristallgitter aufweist.

Es hat sich bei der Herstellung von Streifenwellenleitern auf der Basis von Eisengranat mittels HF-Kathodenzerstäubung gezeigt, daß das Eisengranatmaterial auf einkristallinen Granat-Substraten einkristallin aufwächst, wenn die Substrate auf eine Temperatur $\geq$ 450 °C aufgeheizt werden.

Werden Schichten auf der Basis von Eisengranat auf zumindest in oberflächennahen Bereichen nicht-einkristallinen Substraten, wie z.B. gestörten einkristallinen oder amorphen Substraten abgeschieden, bilden sich bei einer Substrattemperatur unter etwa 520 °C amorphe bis röntgenamorphe Schichten und bei Substrattemperaturen > 520°C polykristalline Schichten.

Nach einer vorteilhaften Weiterbildung des Verfahrens gemäß der Erfindung wird vor Abscheiden des den Wellenleiterstreifen bildenden Materials aus demselben Material zunächst eine einkristalline Eisengranatschicht mittels HF-Kathodenzerstäubung abgeschieden, der ein gegenüber dem Brechungsindex $n_2$ des Wellenleiterstreifens erniedrigter Brechungsindex $n_1$ dadurch erteilt wird, daß entweder eine gegenüber den Bedingungen zur Abscheidung des einkristallinen Wellenleiterstreifens größere HF-Spannung an der Targetelektrode und/oder ein höherer Druck des Inertgasplasmas und/oder eine höhere Substrattemperatur und/oder eine an die Substratelektrode angelegte HF-Spannung (Substrat-bias) eingestellt wird(werden).

Nach einer vorteilhaften weiteren Ausgestaltung des Verfahrens gemäß der Erfindung wird nach Abscheiden des den Wellenleiterstreifen bildenden Materials aus demselben Material eine weitere Eisengranatschicht mittels HF-Kathodenzerstäubung abgeschieden, die auf dem Wellenleiterstreifen einkristallin und auf dem ihn seitlich umgebenden Material amorph oder polykristallin aufwächst und der ein gegenüber dem Brechungsindex $n_2$ des Wellenleiterstreifens erniedrigter Brechungsindex $n_1$ dadurch erteilt wird, daß entweder eine gegenüber den Bedingungen zur Abscheidung des einkristallinen Wellenleiterstreifens größere HF-Spannung an der Targetelektrode und/oder ein höherer Druck des Inertgasplasmas und/oder eine höhere Substrattemperatur und/oder eine an die Substratelektrode angelegte HF-Spannung (Substrat-bias) eingestellt wird(werden).

Nach einer weiteren vorteilhaften Ausgestaltung des Verfahrens nach der Erfindung wird das den Wellenleiterstreifen seitlich umgebende Material in einem nachfolgenden Ätzschritt entfernt und es wird mittels HF-Kathodenzerstäubung eine weitere einkristalline Eisengranatschicht aus dem den Wellenleiterstreifen bildenden Material neben und auf dem Wellenleiterstreifen abgeschieden, der ein gegenüber dem Brechungsindex $n_2$ des Wellenleiterstreifens erniedrigter Brechungsindex $n_1$ dadurch erteilt wird, daß ein Inertgasplasma eines gegenüber dem Inertgasplasma zur Abscheidung des Wellenleiterstreifens erhöhten Drucks, vorzugsweise im Bereich von 0,2 bis 2,0 Pa bei einer Ionenenergie von etwa 10 bis $10^2$ eV, eingesetzt wird. Ein niedrigerer Brechungsindex $n_1$ der weiteren einkristallinen Eisengranatschicht läßt sich auch erreichen, indem die an der Targetelektrode anliegende HF-Spannung oder die Substrattemperatur erhöht wird oder an die Substratelektrode eine HF-Spannung umgelegt wird (Substrat-bias). Alle vier Maßnahmen wirken in Richtung der Erhöhung der selektiven Rückstäubungsrate von am Schichtaufbau beteiligten Elementen mit besonders niedriger Zerstäubungsrate (z.B. Wismut). Da amorphes Eisengranatmaterial bei z.B. einem chemischen Ätzprozeß in $H_3PO_4$ und bei einer Temperatur von 150 °C eine etwa um den Faktor 5 größere Ätzrate als einkristallines Eisengranatmaterial hat, und die Ätzrate eines nicht-magnetischen Gadolinium-Gallium-Granat-Substrats noch einmal um den Faktor 2 geringer ist, als die von einkristallinem Eisengranat, läßt sich das die einkristallinen Wellenleiterstreifen umgebende Material in Form von amorphem Eisengranat quantitativ entfernen ohne die einkristallinen Wellenleiterstreifen zu beschädigen. Die einkristallinen Wellenleiterstreifen müssen, wie oben ausgeführt, rundherum von Material eines Brechungsindex umgeben sein, der für die gewünschte geführte Mode des eingestrahlten Lichtes niedriger und im Fall eines halbabstrahlenden optischen Isolators für die zur geführten Mode komplementären Moden größer ist. Dies kann nach Entfernen des die einkristallinen Wellenleiterstreifen umgebenden amorphen Materials durch das Abscheiden der weiteren einkristallinen Eisengranatschicht erreicht werden.

Je nach Höhe des Drucks des während der epitaxialen Abscheidung aufrechterhaltenen Inertgasplasmas findet ein geringer, unterschiedlich starker Teilchenbeschuß der wachsenden Schicht statt, wodurch schwache Rückstäubungseffekte modifiziert werden. Je niedriger der Druck des Inertgasplasmas, desto geringer ist der Teilchenbeschuß der anwachsenden Schicht aufgrund der erhöhten Plasmadichte, desto ähnlicher ist also die Zusammensetzung der abgeschiedenen Schicht der des Targets. Wird der Druck des Inertgasplasmas gering-

EP 0 252 536 B1

fügig erniedrigt, ändert sich die Zusammensetzung der abgeschiedenen Schicht infolge verringerten Teilchenbeschusses. Dieses Phänomen wird dazu ausgenutzt, Eisengranatmaterial infolge der Rückstäubungseffekte geringfügig unterschiedlicher Zusammensetzung und damit mit unterschiedlichen Brechungsindices $n_2$ oder $n_1$ epitaktisch abzuscheiden. Bei einer Magnetron-Kathodenzerstäubung sind diese Effekte nur in amorphem Eisengranat ausgeprägter, da offenbar die Oberflächenbindungsenergie gewisser Bestandteile der Schicht kleiner ist, als in kristallinem Material.

Nach vorteilhaften Weiterbildungen des erfindungsgemäßen Verfahrens wird auf der das Substrat bildenden Einkristallscheibe, vorzugsweise durch Flüssigphasenepitaxie, eine einkristalline Kobalt-substituierte Eisengranatschicht als Absorberschicht oder es wird auf der weiteren Eisengranatschicht mittels HF-Kathodenzerstäubung eine amorphe Eisengranatschicht einer der Zusammensetzung des Wellenleiterstreifens entsprechende Zusammensetzung als Absorberschicht abgeschieden, der ein gegenüber dem Brechungsindex $n_1$ der weiteren Eisengranatschicht gleicher oder erhöhter Brechungsindex $n_3$ dadurch erteilt wird, daß ein gegenüber den Bedingungen zur Abscheidung der weiteren Eisengranatschicht geringerer Druck des Inertgasplasmas, vorzugsweise im Bereich von 0,1 bis 1 Pa, und/oder eine niedrigere Substrattemperatur, vorzugsweise im Bereich von 200 bis 450 °C, eingestellt werden. Für die Funktionsweise von Monomode-Wellenleitern ist es grundsätzlich erforderlich, daß unerwünschte Moden unterdrückt werden. Das als Absorber wirkende Material braucht den Streifenwellenleiter dabei nicht vollständig zu umschließen, es ist ausreichend, wenn eine Absorberschicht entweder oberhalb oder unterhalb der den Streifenwellenleiter bildenden Schichtstruktur vorgesehen wird.

Nach vorteilhaften Weiterbildungen des Verfahrens nach der Erfindung werden der einkristalline Wellenleiterstreifen und ihn umgebendes Material in einem Inertgasplasma eines Drucks von 0,2 bis 2,0 Pa und die weitere Eisengranatschicht in einem Inertgasplasma des gleichen Druckbereiches jedoch gegenüber dem Druck zur Abscheidung des Wellenleiterstreifens erhöhten Druckes abgeschieden.

Nach einer weiteren vorteilhaften Ausgestaltung des erfindungsgemäßen Verfahrens wird die Gitterstruktur des Substrats in Form einer Granat-Einkristallscheibe oder die Gitterstruktur der auf einer ungestörten Granat-Einkristallscheiben angebrachten einkristallinen Absorberschicht oder die Gitterstruktur der auf einer ungestörten einkristallinen Absorberschicht angebrachten ersten einkristallinen Eisengranatschicht bis in einige Atomlagen Tiefe durch Ionenbeschuß aus einem Inertgasplasma in den Bereichen, auf denen kein Wellenleiterstreifen epitaktisch aufwachsen soll, gestört. Ein Sputterätzprozeß (Ionenbeschuß aus dem Plasma) bei relativ kleinen HF-Spannungen und bei relativ kleinen Drucken des Sputtergases ist geeignet, ein mittels Kathodenzerstäubung epitaktisch zu beschichtendes einkristallines Substrat in oberflächennahen Bereichen einer Tiefe von nur wenigen Atomlagen so in seiner Gitterstruktur zu stören, daß je nach Substrattemperatur auf diesen gestörten Oberflächen keine einkristalline, sondern eine Schicht anderer Ordnung, vorzugsweise eine amorphe oder polykristalline Schicht, aufwächst neben einer einkristallinen Schicht auf den ungestörten Bereichen des Substrats. Hiermit ist der Vorteil verbunden, daß mit ein und derselben Vorrichtung während des gesamten Prozesses gearbeitet werden kann und daß eine ausreichende Gitterstörung von nur wenigen Atomlagen Tiefe erreicht wird. Vorzugsweise werden die durch Ionenbeschuß nicht zu störenden Bereiche mit einer Photolackmaske abgedeckt und der Ionenbeschuß wird anschließend in einem Edelgasplasma eines Drucks von 0,1 bis 1 Pa bei einer Ionenenergie > 30 eV durchgeführt.

Nach einer weiteren vorteilhaften Ausgestaltung des Verfahrens nach der Erfindung wird als Targetelektrode ein Magnetron, in das die für den Zerstäubungsprozeß erforderliche HF-Leistung eingespeist wird, eingesetzt. Ein Magnetron bewirkt, daß das Plasma in Targetnähe konzentriert und somit der Ionenbeschuß der wachsenden Schicht drastisch vermindert wird, so daß z.B. keine das epitaxiale Wachstum beeinträchtigenden Rückstäubungseffekte an der Schicht auftreten. Bei Verwendung einer Magnetronelektrode ist es zweckmäßig, für das zu zerstäubende Target eine Phasenzusammensetzung zu wählen, die eine möglichst kleine Sättigungsmagnetisierung aufweist, um eine weitestgehende Konzentrierung des Plasmas in Targetnähe zu bewirken.

Mit der Anwendung eines Magnetrons ist darüberhinaus der Vorteil verbunden, daß der Abstand zwischen Target und Substrat im Vergleich zu Verfahren, die mit HF-Kathodenzerstäubungsanlagen in Diodenanordnung arbeiten, optimiert werden kann im Sinne einer möglichst geringen Plasmadichte und kinetischen Energie in der Nähe des Substrats bei einer möglichst hohen Abscheidungsrate.

Nach einer vorteilhaften Weiterbildung des erfindungsgemäßen Verfahrens wird das System aus Substrat, einkristallinem Wellenleiterstreifen und ihn umgebendem amorphem Material einem Temperprozeß unterzogen bei einer Temperatur, bei der laterales epitaxiales Wachstum von den Flanken des Wellenleiterstreifens in das ihn umgebende amorphe Material erfolgt, derart, daß seitlich zum Wellenleiterstreifen eine einkristalline Ummantelung von einigen µm Dicke entsteht. Auch auf diese Weise werden einkristalline Wellenleiterstreifen erhalten mit steilen, homogenen, glatten und abrupten Grenzflächen zu dem sie umgebenden amorphen Material.

5

Der Temperprozeß wird vorteilhafterweise innerhalb eines Temperaturbereiches von etwa 50 K unterhalb der Kristallisationstemperatur des amorphen Material durchgeführt. Hierdurch wird der Wert für die Absorption $\alpha_1$ des amorphen Eisengranatmaterials an die Absorption $\alpha_2$ des einkristallinen Eisengranatmaterials angenähert, was zu einer Verminderung von Wellenleitungsverlusten einer in den Streifenwellenleiter einleckenden Lichtwelle führt. Wegen der ähnlichen Zusammensetzung der amorphen Schicht ist der Brechungsindex zum kristallisierten Material entsprechend abgestuft.

Das Verfahren nach der Erfindung weist folgende Vorteile auf:

Mit dem vorliegenden Verfahren ist es möglich, optische Streifenwellenleiter, insbesondere vom eingebetteten (buried) channel wave guide-Typ mit Isolator-Eigenschaft mit einem epitaxialen Abscheidungsprozeß in einem einzigen Arbeitsgang herzustellen, wobei die erhaltenen Streifenwellenleiter hinsichtlich Struktur, Brechungsindex und magnetischer Eigenschaften homogen über ihren gesamten Querschnitt sind, eine hohe geometrische Auflösung zeigen und sich durch glatte, steile Grenzflächen zwischen einkristallinem und Material anderer Ordnung (amorph oder polykristallin) auszeichnen.

Die Grenzfläche zwischen amorphen und einkristallinen Bereichen weist im Wellenlängenbereich oberhalb 1 μm einen durch das vorliegende Verfahren einstellbaren Brechungsindexsprung zu kleineren Werten auf, wie er für Wellenführung in einkristallinen Wellenleiterstreifen erforderlich ist. Die intrinsische Absorption $\alpha$ des durch HF-Kathodenzerstäubung hergestellten einkristallinen Eisengranats ist im Wellenlängenbereich oberhalb 1 μm äußerst gering; mit Hilfe einer Wellenleitungsmethode wurde bei einer Wellenlänge von 1,33 μm in der Schichtebene ein Gesamtverlust $\alpha$ von $< 0,15$ cm$^{-1}$ gemessen, der auch die Streuverluste des ebenen Wellenleiters enthält. Die Grenzfläche zwischen amorphem und einkristallinem Material ist sehr glatt und steil, was auch im Wellenleiterstreifen zu geringen Streuverlusten führt. Die geometrische Auflösung der mit dem vorliegenden Verfahren hergestellten Strukturen liegt bei $< \pm 1,5$ μm.

Ein anderer Vorteil des vorliegenden Verfahrens ist, daß zur Herstellung von einkristallinen Wellenleiterstreifen neben Material anderer Ordnung (amorph oder polykristallin) mit einer einzigen Vorrichtung und in einem einzigen Arbeitsgang sowohl die Vorbereitung der zu beschichtenden Substrate (Ionenbeschuß) als auch die Herstellung der Eisengranatschichten vorgenommen werden kann, was für einen Fertigungsprozeß von wirtschaftlicher Bedeutung ist.

Ein weiterer Vorteil des vorliegenden Verfahrens ist, daß sehr dünne homogene Schichten herstellbar sind, weil keine Übergangs-Schichten, wie sie bei der Flüssigphasenepitaxie auftreten, gebildet werden.

Vorteilhaft beim vorliegenden Verfahren ist z.B. für die Herstellung von Eisengranatschichten auf einem nicht-magnetischen Substrat auch, daß die Anpassung der Gitterkonstanten von Substrat und Schicht geringere Probleme bereitet, als z.B. bei der Flüssigphasenepitaxie; Gitterfehlanpassungen von $> 1\%$ sind tolerierbar. Sie werden sogar in dieser Größenordnung gefordert, wenn es um die Realisierung optischer Isolatorkonzepte mit semi-leaky-Eigenschaften geht.

Für die HF-Kathodenzerstäubung können im Handel erhältliche, mit HF-Spannung zu betreibende Kathodenzerstäubungsanlagen mit einer mit Magnetsystem ausgestatteten Targetkathode (Magnetron), z.B. eines Durchmessers von 7,6 cm, benutzt werden, wobei eine Vorrichtung zur Messung der effektiven HF-Spannung sowohl an der Targetelektrode als auch an der Substratelektrode vorzusehen ist. Die Magnetronkathode ist liegend in einen herkömmlichen Vakuumrezipienten eingebaut. Die für den Zerstäubungsprozeß erforderliche HF-Leistung wird vom HF-Generator über Impedanzanpassungsglieder in die Targetelektrode und in die Substratelektrode eingespeist und so dem Plasma zugeführt. Die Konstanthaltung der HF-Spannung an der Targetelektrode auf Werte besser als $\pm 1\%$ wird über eine Rechnersteuerung erreicht. Ebenfalls wird der Druck des Sputtergases durch Rechnersteuerung auf besser als $\pm 1\%$ konstant gehalten. Als Energiequelle für die Zerstäubungseinrichtung dient ein normaler HF-Generator, der bei einer Ausgangsleistung von 200 W betrieben wird.

Die Betriebsfrequenz liegt bei 13,56 MHz.

Zur Erläuterung der Erfindung werden Ausführungsbeispiele beschrieben.

Die Zeichnung zeigt:

Fig. 1a bis 1c Streifenwellenleiter-Typen, wie sie aus dem Stand der Technik bekannt sind,

Fig. 2 graphische Darstellung von Brechungsindices für die Materialien eines Streifenwellenleiters nach der Erfindung,

Fig. 3 graphische Darstellung der intrinsischen Absorption $\alpha$ für die Materialien eines Streifenwellenleiters nach der Erfindung.

Fig. 4 bis 7 Ausschnitte von Streifenwellenleitern nach der Erfindung im Schnitt.

In den Figuren 1a bis 1c sind schematisch im Schnitt Streifenwellenleiter-Typen dargestellt, wie sie aus dem Stand der Technik bekannt sind (Figur 1a: strip-loaded waveguide, Figur 1b: ridged waveguide, Figur 1c: channel waveguide). Mit WL ist der Wellenleiterstreifen bezeichnet, mit S das Substrat. Die dargestellten Streifenwellenleiter bestehen aus Materialien der Brechungsindices $n_1$, $n_2$ und $n_3$, wobei die Bedingung gilt: $n_3 \geq$

$n_2 > n_1$.

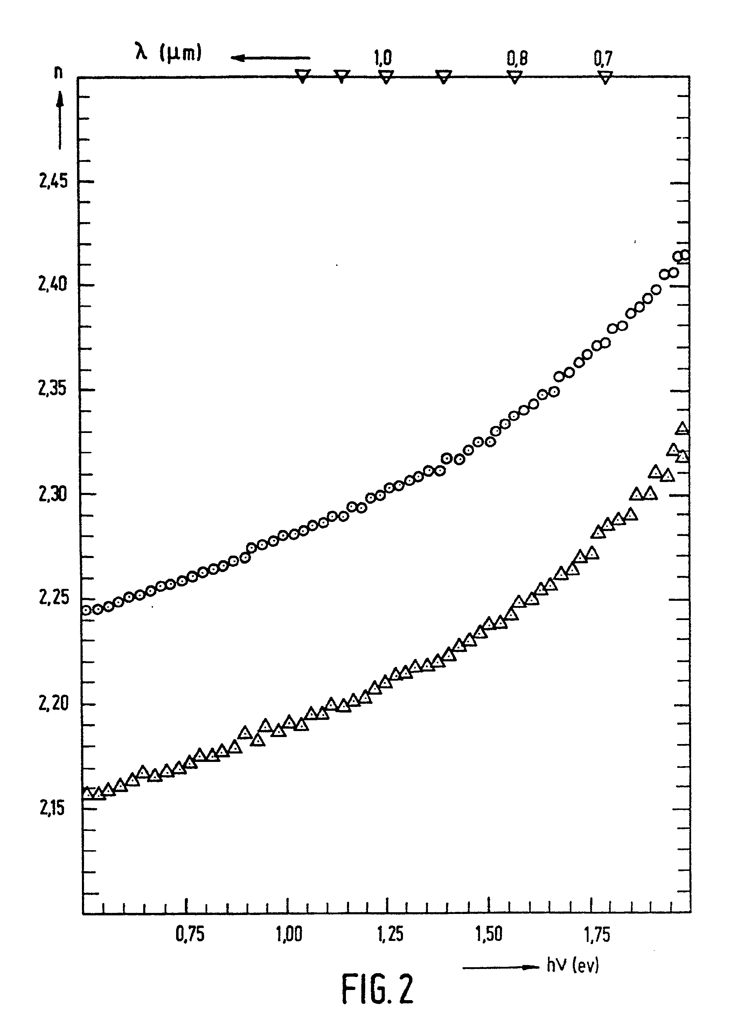

In Figur 2 ist der Brechungsindex n von einkristallinem (Kreise) und amorphen (Dreiecke) in situ abgeschiedenen Wismut-substituiertem Gadolinium-Eisengranat, bei dem ein Teil des Eisens durch Aluminium und Gallium ersetzt wurde, in bezug zur Wellenlänge $\lambda$ ($\mu$m) und der Photonenenergie h $\nu$ (eV) aufgetragen.

Aus der Figur ergibt sich, daß die Grenzfläche zwischen amorphem und einkristallinem Material im für Streifenwellenleiter interessierenden Wellenlängenbereich oberhalb 1 $\mu$m einen Brechungsindexsprung zu kleineren Werten aufweist, wie er für eine Wellenführung in einkristallinen Wellenleiterstreifen erforderlich ist. Dieser Brechungsindexsprung ist gemäß dem vorliegenden Verfahren einstellbar, also auch, wie z.B. bei dickeren Monomode-Wellenleitern gefordert, sehr klein zu machen.

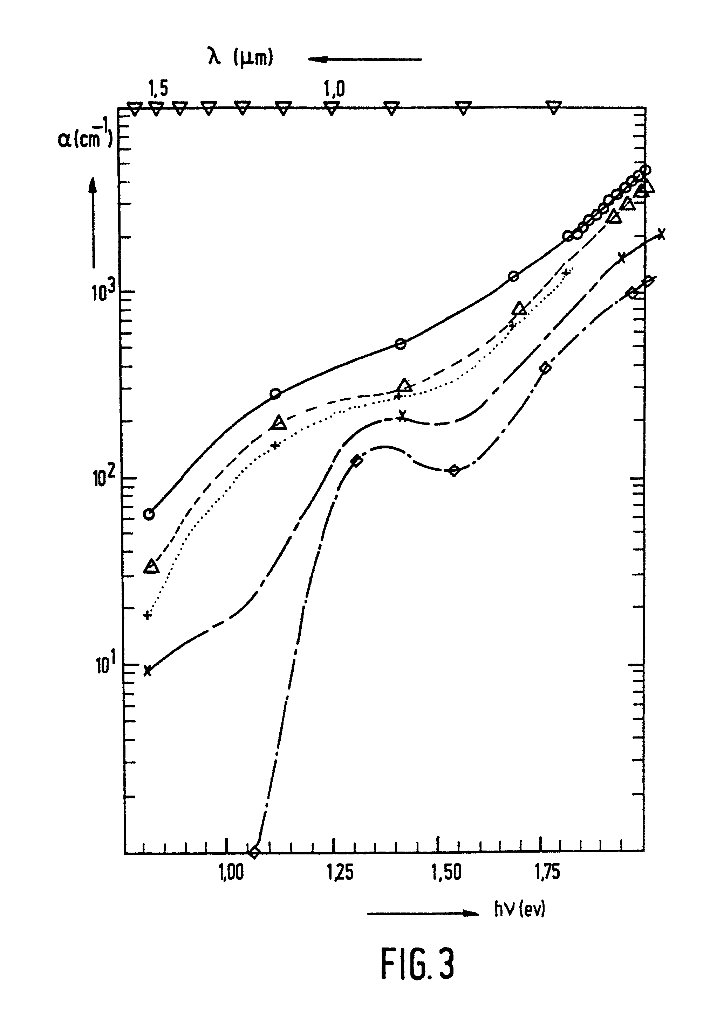

In Figur 3 ist die intrinsische Absorption $\alpha$ (1/cm) von einkristallinem und amorphem, in situ abgeschiedenen Wismut-substituiertem Gadolinium-Eisengranat, bei dem ein Teil des Eisens durch Aluminium und Gallium ersetzt wurde, in bezug zur Wellenlänge $\lambda$ ($\mu$m) und zur Photonenenergie h $\nu$ (eV) aufgetragen. Dabei sind von unten nach oben eingetragen: einkristallines Material (Kurve 1) Wachstumstemperatur 520 °C); dasselbe Material eine halbe Stunde getempert bei 690 °C (Kurve 2), bei 660°C (Kurve 3) und bei 550 °C (Kurve 4), und amorphes Material (Kurve 5) (Abscheidetemperatur 360 °C). Es zeigt sich aus der Figur, daß die intrinsische Absorption $\alpha$ des mittels HF-Kathodenzerstäubung hergestellten einkristallinen Eisengranat-materials im für die Wellenleiter-Anwendung interessierenden Wellenlängenbereich oberhalb 1 $\mu$m sehr gering ist. Demgegenüber hat der amorphe Eisengranat eine für die Verwendung als Absorberschicht für die Unterdrückung unerwünschten Moden ausreichend hohe Absorption. Die Absorption $\alpha_1$ des amorphen Eisengranat-Materials läßt sich darüberhinaus mit dem vorliegenden Verfahren durch Tempern bei einer Temperatur nahe der Kristallisationstemperatur der Absorption $\alpha_2$ des einkristallinen Materials annähern, was für die Herstellung von verlustarmen Streifenwellenleitern vom channel waveguide-Typ wichtig ist.

Als Ausführungsbeispiel wird die Herstellung von Streifenwellenleitern für nicht-reziproke optische Bauelemente mit einkristallinen Wellenleiterstreifen und sie umgebendem Material anderer Ordnung aus Wismut-substituiertem Gadolinium-Eisen-Granat, bei dem ein Teil des Eisens durch Aluminium und Gallium substituiert ist, beschrieben.

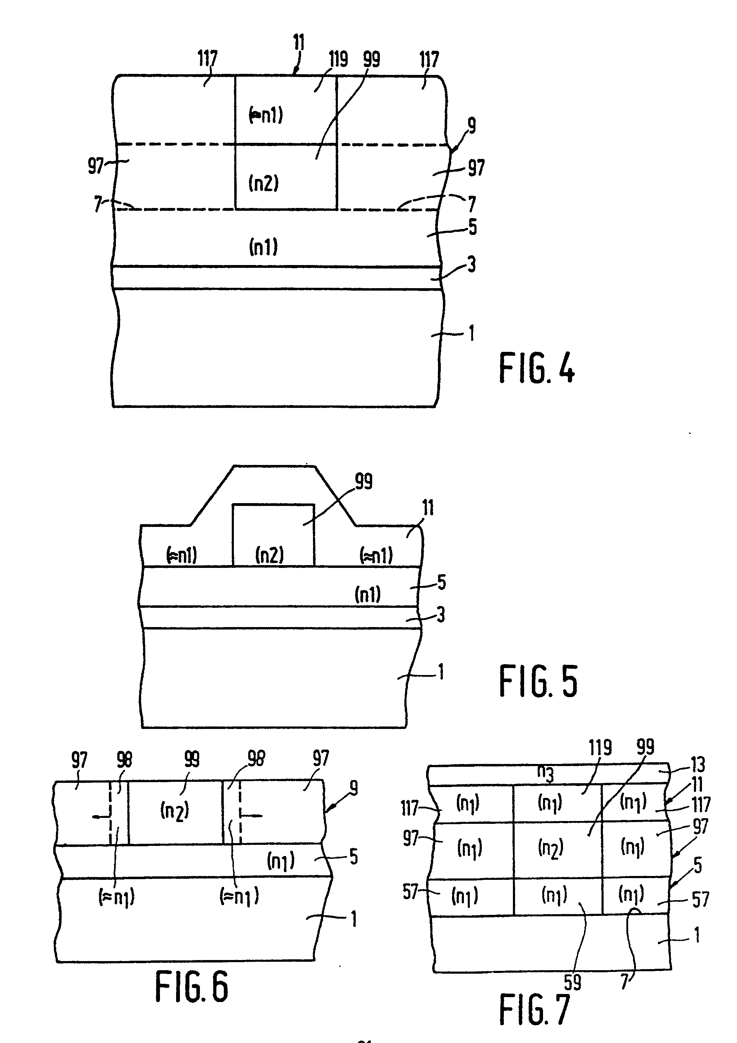

Als Substrate wurden in (111)-Richtung oder in (110)-Richtung orientierte Calcium-Magnesium-Zirkonium-substituierte Gadolinium-Gallium-Granat-Einkristallscheiben 1 eines Durchmessers von 30 mm verwendet, die vor dem Abscheidungsprozeß auf bekannte Weise derart vorbehandelt wurden, daß epitaxiales Wachstum auf ihnen erfolgen kann. Auf diese Substrate wird zunächst mittels HF-Kathodenzerstäubung eine erste einkristalline Schicht 5 (vergleiche Figuren 4 bis 6) aus Wismut-substituiertem Gadolinium-Eisen-Granat, bei dem ein Teil des Eisens durch Aluminium und Gallium substituiert ist, aufgebracht. Diese Eisengranatschicht 5 wird mit Hilfe desselben Targets abgeschieden, das zur späteren Herstellung von einkristallinen Wellenleiterstreifen 99 und des sie umgebenden Materials 97 eingesetzt wird. Dieser ersten Eisengranatschicht 5 wird durch geeignete Wahl der Sputterparameter ein Brechungsindex $n_1$ erteilt, der kleiner ist als der Brechungsindex $n_2$ des auf ihr später abzuscheidenden einkristallinen Wellenleiterstreifenmaterials dadurch, daß entweder eine gegenüber den Bedingungen zur Abscheidung der einkristallinen Wellenleiterstreifen größere HF-Spannung an der Targetelektrode und/oder ein höherer Druck des Inertgasplasmas und/oder eine höhere Substrattemperatur und/oder eine an die Substratelektrode angelegte HF-Spannung (Substrat-bias) eingestellt wird. Zur Abscheidung der ersten einkristallinen Eisengranatschicht 5 wird ein Edelgas, vorzugsweise Argon, eines Drucks von 0,6 Pa in die bis zu einem Druck von $<10^{-5}$ mbar evakuierte Zerstäubungsapparatur eingeleitet. Eine solche Schicht mit einem Brechungsindex $n_1$, der kleiner ist als der des anschließend aufzubringenden Wellenleiterstreifens ist erforderlich, um eine Monomode-Wellenleitung in dem herzustellenden Streifenwellenleiter zu erreichen. Eine Druckdifferenz des Inertgasplasmas von z.B. etwa 0,5 Pa führt zu einem Brechungsindexsprung von etwa $5.10^{-3}$.

Anschließend oder vor Anbringen der ersten epitaxialen Eisengranatschicht 5 wird das Substrat zur Herstellung einer örtlich gestörten Gitterstruktur mit einer Photolackmaske an den Stellen, an denen zum epitaktischen Aufwachsen des Wellenleiterstreifens die Gitterstruktur nicht gestört werden soll, versehen und einem Ionenbeschuß in einem Edelgasplasma eines Drucks von 0,1 bis 1 Pa, vorzugsweise 0,2 Pa bei einer Ionenenergie > 30 eV, vorzugsweise einigen $10^2$ eV unterzogen. Danach wird die Photolackmaske entfernt. Die übrigen Verfahrensparameter entsprechen denen, wie sie zur Herstellung der einkristallinen Wellenleiterstreifen und des sie umgebenden Materials weiter unten beschrieben werden.

Als Target (kathodische Zerstäubungsquelle) dient ein durch Heißpressen oder Sintern aus Eisengranat-Mischoxiden hergestellter Körper eines Durchmessers von 7,5 cm einer Dicke von 4 mm und einer Porosität von < 10 % und vorzugsweise einer Sättigungsmagnetisierung $M_s < 25$ G.

Für die nachfolgenden Ausführungsbeispiele werden Pulvergemische aus $BiFeO_3$, $Gd_2Bi_1Fe_5O_{12}$, $Al_2O_3$

und $Ga_2O_3$ in Sauerstoffatmosphäre eines Drucks von 1 bar über eine Dauer von 6 h bei einer Temperatur < 920 °C gesintert, wobei der Prozeß so geführt wird, daß kaum freies $Bi_2O_3$ im Keramikgefüge zurückbleibt. Freies $Bi_2O_3$ soll deswegen nicht im Target vorhanden sein, weil es zur mechanischen Desintegration der Oberfläche des Targets durch seine gegenüber den anderen Targetbestandteilen erhöhte Zerstäubungsrate führt; durch die Verwendung von Mischoxiden wird eine Homogenisierung der Zerstäubungsrate aller Phasenbestandteile des Targets erreicht.

## Beispiel I

Zur Herstellung von einkristallinen einphasigen Eisengranat-Wellenleiterstreifen und sie umgebendem amorphem Material der Zusammensetzung $Gd_{1,90}Bi_{1,45}Fe_{4,09}Al_{0,34}Ga_{0,22}O_{12}$ wird ein Target eines Durchmessers von 7,5 cm folgender Zusammensetzung verwendet (Angaben in Gew.%):

| | |
|---|---|
| $Gd_2O_3$ | 33,64 |
| $Bi_2O_3$ | 31,80 |
| $Fe_2O_3$ | 31,52 |
| $Al_2O_3$ | 1,15 |
| $Ga_2O_3$ | 1,89 |

Der Targetkörper wird auf der Targetelektrode mit einem gut wärmeleitenden Kleber (z.B. mit Silberpulver gefülltes Epoxydharz) befestigt.

Um Verlustwärme abzuführen, ist es zweckmäßig, z.B. durch Wasser, gekühlte Targetelektroden zu verwenden.

Der Abscheidungsprozeß wird so geführt, daß die Zerstäubungsapparatur zunächst mit einer Vakuumpumpe bis zu einem Druck von < $10^{-3}$ Pa evakuiert wird, anschließend wird ein Edelgas, vorzugsweise Argon, eines Drucks von 0,6 Pa eingeleitet. Der Abstand zwischen Target und Substrat beträgt 80 mm. Die Niederschlagsrate liegt bei etwa 0,8 µm/h. Die an der HF-Zuleitung an der Rückseite der Targetelektrode gemessene HF-Spannung beträgt 230 $V_{eff}$, die Substratspannung ist schwebend. Die Substrattemperatur beträgt 480 °C.

## Beispiel II

Zur Herstellung von einkristallinen einphasigen Eisengranat-Wellenleiterstreifen und sie umgebendem amorphem Material der Zusammensetzung $Gd_{1,97}Bi_{1,04}Fe_{4,51}Ga_{0,22}Al_{0,26}O_{12}$ wird ein Target eines Durchmessers von 7,5 cm mit folgender Zusammensetzung verwendet (Angaben in Gew.%):

| | |
|---|---|
| $Gd_2O_3$ | 36,514 |
| $Bi_2O_3$ | 24,122 |
| $Fe_2O_3$ | 36,074 |
| $Al_2O_3$ | 1,220 |
| $Ga_2O_3$ | 2,070. |

Der Targetkörper wird auf der Targetelektrode, wie zu Beispiel I beschrieben, befestigt. Es ist ebenfalls zweckmäßig um Verlustwärme abzuführen, durch Wasser gekühlte Targetelektroden zu verwenden. Der Beschichtungsprozeß wird wie zu Beispiel I beschrieben durchgeführt, die Substrattemperatur betrug 510 °C.

Vor der Abscheidung der Schichten (typische Schichtdicken liegen bei 1 bis 5 µm) wird das Target durch Ionenbeschuß aus dem Plasma so lange angeätzt, bis sich eine konstante Zusammensetzung des abgestäubten Targetmaterials eingestellt hat. Diese Vorätzzeit reduziert sich bei weiteren Experimenten mit ein und demselben Target von 5 h bis auf einige 10 min, bis sich am Target das Gleichgewichtspotential stabilisiert hat.

Nach Abscheiden in der Kathodenzerstäubungsanlage werden Schichten erhalten, die auf den Substratbereichen mit einer Gitterfehlordnung amorph bzw. röntgenamorph oder polykristallin sind und auf den Substratbereichen mit einkristallinem, ungestörtem Kristallgitter einkristallin.

In den Figuren 4,5,6 und 7 sind Streifenwellenleiterstrukturen schematisch dargestellt, wie sie nach dem vorliegenden Verfahren hergestellt wurden.

Figur 4. Auf einem nicht-magnetischen, in (110)-Richtung orientierten Gadolinium-Gallium-Granat-Substrat 1 wird vorzugsweise durch Flüssigphasenepitaxie zunächst eine Kobalt-substituierte Eisengranatschicht 3 angebracht; diese Schicht 3 hat die Funktion, das Auftreten von höheren Wellenmoden an der Grenzfläche zum Substrat durch erhöhte Absorption zu verhindern. Grundsätzlich ist es, wie bereits dargestellt, für die Funktionsweise von Monomode-Wellenleitern erforderlich, daß unerwünschte Moden unterdrückt werden, wobei das absorbierende Material den Streifenwellenleiter nicht vollständig umschließen muß. Alternativ zu der oben genannten Kobalt-substituierten einkristallinen Eisengranatschicht kann beispielsweise auch eine mittels HF-Kathodenzerstäubung hergestellte Absorberschicht aus amorphem Eisengranat eingesetzt werden, die ober-

EP 0 252 536 B1

halb der Streifenwellenleiterstruktur angebracht ist (hierzu wird auf Figur 7 verwiesen).

Anschließend wird wie vorstehend beschrieben, die erste einkristalline Eisengranatschicht 5 mittels HF-Kathodenzerstäubung angebracht. Das so vorbereitete Substrat 1,3,5 wird, wie bereits beschrieben, durch Ionenbeschuß in oberflächennahen Gitterbereichen gestört; in Figur 4 sind dies die Bereiche 7, auf denen im späteren Abscheidungsprozeß eine Eisengranatschicht 9 mit amorphen oder polykristallinen Bereichen 97 aufwächst. In den nicht-gestörten Gitterbereichen der Schicht 5 wächst Eisengranat im späteren Abscheidungsprozeß einkristallin auf unter Bildung eines Wellenleiterstreifens 99. Anschließend wird ebenfalls mittels HF-Kathodenzerstäubung unter Anwendung desselben Targets, wie es zur Herstellung des Wellenleiterstreifens 99 und der amorphen oder polykristallinen Bereiche 97 eingesetzt wurde, eine weitere Eisengranatschicht 11 abgeschieden, die im Bereich 119 oberhalb des Wellenleiterstreifens 99 einkristallin und in den Bereichen 117 oberhalb der amorphen oder polykristallinen Bereiche 97 amorph oder polykristallin aufwächst. Dieser weiteren Eisengranatschicht 11 wird ein gegenüber der Eisengranatschicht 9 niedrigerer Brechungsindex $n_1$ dadurch erteilt, daß zu ihrer Abscheidung entweder eine gegenüber den Bedingungen zur Herstellung der Eisengranatschicht 9 größere HF-Spannung an der Targetelektrode, ein höherer Druck des Inertgasplasmas, eine höhere Substrattemperatur oder eine an die Substratelektrode angelegte HF-Spannung (Substratbias), z.B. < 25 $V_{eff}$ eingestellt wird. Bei dem hier beschriebenen Beispiel wurde so verfahren, daß zur Abscheidung der weiteren Eisengranatschicht 11 ein Inertgasplasmadruck von 1,0 Pa und eine Substrattemperatur im Bereich von 480 bis 540 °C eingestellt wurde. Bei einer Substrattemperatur von 480 °C wächst die Eisengranatschicht 11 in den Bereichen 117 amorph auf, bei einer Substrattemperatur von > 540 °C wächst sie in den Bereichen 117 polykristallin auf.

Figur 5 zeigt einen Teil einer weiteren Ausführungsform eines Streifenwellenleiters, wie er nach dem Verfahren gemäß der Erfindung hergestellt wurde. Die Verfahrensschritte bis zur Herstellung der Schicht 9 sind die gleichen wie zu Figur 4 beschrieben; die Schicht 9 gemäß Figur 4 hat einen einkristallinen Wellenleiterstreifen 99 sowie z.B. amorphe Bereiche 97 neben dem Wellenleiterstreifen 99. Das so erhaltene System aus Substrat 1,3,5 und der Schicht 9 wird nun in einem nachfolgenden chemischen Ätzprozeß in $H_3PO_4$ bei einer Temperatur von ≈ 150 °C geätzt, wobei die amorphen Schichtteile 97 entfernt werden und der Wellenleiterstreifen 99 wegen seiner gegenüber dem amorphen Material der Schichtteile 97 um den Faktor etwa 5 geringeren Ätzrate erhalten bleibt.

Auf der so erhaltenen Struktur aus Substrat 1,3,5 und einkristallinem Wellenleiterstreifen 99 wird in einem anschließenden Prozeßschritt die weitere einkristalline Eisengranatschicht 11, wie zu Figur 4 beschrieben, mittels HF-Kathodenzerstäubung angebracht.

Ein halb abstrahlender optischer Isolator ("semi-leaky isolator", wie in I.E.E.E. J. Quantum Electr. QE-18, 1982, Seite 1975 beschrieben), der Monomode-Wellenleitung aufweist, wird z.B. erhalten, wenn der einkristalline Wellenleiterstreifen 99 einen Querschnitt von ≥ 3,5x3,5 $\mu m^2$ hat bei einem Brechungsindexsprung für die geführte Mode von $n_2$-$n_1$ ≤ 5.10$^{-3}$, während für die abzustrahlende Mode der Brechungsindexsprung $n_2$-$n_1$ ≤ 0 sein muß. Um geringe Wellenleitungsverluste im Isolator zu erreichen, muß der Wert für die intrinsische Absorption $\alpha_1$ des den Wellenleiterstreifen umgebenden Materials dem kleinen Wert für die intrinsische Absorption $\alpha_2$ des Materials des einkristallinen Wellenleiterstreifens 99 nahekommen, und es muß eine sehr glatte Grenzfläche zwischen dem einkristallinen Wellenleiterstreifen 99 und dem ihn umgebenden Material vorhanden sein. Die Werte für die Absorption $\alpha_1$, $\alpha_2$ sind für die Materialien des einkristallinen Wellenleiterstreifens 99 und der weiteren einkristallinen Schicht 11 praktisch gleich.

Der erforderliche Brechungsindexsprung $n_2$-$n_1$ ≤ 5.10$^{-3}$ für die geführte Mode kann durch unterschiedliche Substrattemperaturen während der Abscheidung des einkristallinen Streifenwellenleiters 99 und der weiteren einkristallinen Schicht 11 erreicht werden; eine Änderung der Substrattemperatur $\Delta T$ = 50 K führt z.B. zu einer Änderung der Gitterkonstanten $a_1$ des Wellenleiterstreifens 99 gegenüber der Gitterkonstanten $a_1$ der Substratschicht 5 entsprechend $\Delta a^\perp$ ≈ 0,001 nm, was zu einem Wert $\Delta n^\perp$ ≈ 5.10$^{-4}$ führt infolge Änderung der Kristallgitterfehlanpassung. Hauptsächlich aber wird der Brechungsindex durch den hierdurch geänderten Wismutgehalt der Schicht verändert.

Diese Brechungsindexänderung liegt im Bereich von 10$^{-3}$.

Eine Grobabstimmung der Brechungsindices $n_2$ des Materials des Wellenleiterstreifens 99 und $n_1$ des Materials der weiteren einkristallinen Schicht 11 kann durch eine an die Substratelektrode angelegte Spannung (Substrat-bias) im Bereich von 20 bis 30 $V_{eff}$ erreicht werden; hierdurch werden Werte $\Delta n$ ≈ 10$^{-1}$ bis 10$^{-2}$ erhalten. Für die abzustrahlenden Moden bei Einsatz des erfindungsgemäßen Streifenwellenleiters als halb-abstrahlender optischer Isolator wird der erforderliche Brechungsindexsprung $n_2$-$n_1$ ≤ 0 dadurch erreicht, daß entweder der Wellenleiterstreifen zumindest teilweise von Material nicht einkristalliner Ordnung umgeben ist oder daß der Wellenleiterstreifen zumindest teilweise von Material einkristalliner Ordnung umgeben ist, dessen Kristallgitterkonstante ähnlich der des Materials des Streifenwellenleiters ist.

Im Fall des zu Figur 4 beschriebenen Streifenwellenleiters erfolgt die Einstellung des Brechungsindex-

sprunges $n_2$-$n_1$ wie oben zu Figur 5 beschrieben. Da das Material des einkristallinen Wellenleiterstreifens 99 einen Wert der Absorption $\alpha_2$ hat, der von dem Wert $\alpha_1$ für das ihn umgebende amorphe Material der Bereiche 97 abweicht, muß hier eine Angleichung von $\alpha_1$ an $\alpha_2$ herbeigeführt werden. Dies kann durch einen Temperprozeß nach Abscheiden des Materials für den Wellenleiterstreifen 99 und des ihn umgebenden Materials der Bereiche 97 gemäß dem Diagramm in Figur 3 erreicht werden.

Figur 6 zeigt einen Teil eines weiteren Streifenwellenleiters, wie er nach dem Verfahren gemäß der Erfindung hergestellt wurde. Auf einem nicht-magnetischen, in (111)-Richtung orientierten Gadolinium-Gallium-Granat-Substrat 1 wird, wie oben bereits beschrieben, die erste einkristalline Eisengranatschicht 5 mittels HF-Kathodenzerstäubung angebracht.

Das so vorbereitete Substrat 1, 5 wird, wie ebenfalls bereits beschrieben, durch Ionenbeschuß in oberflächennahen Gitterbereichen gestört. Anschließend wird die Eisengranatschicht 9 mit amorphen Bereichen 97 und dem auf den nicht-gestörten Bereichen des Substrats 1, 5 einkristallin aufgewachsenen Wellenleiterstreifen 99 mittels HF-Kathodenzerstäubung, wie bereits beschrieben, abgeschieden. Durch einen anschließenden Temperprozeß bei einer Temperatur dicht unterhalb der Kristallisationstemperatur des amorphen Materials der Bereiche 97 werden im Grenzbereich zwischen dem einkristallinen Wellenleiterstreifen 99 und dem angrenzenden amorphen Material der Bereiche 97 einkristalline Randzonen in Form einer Ummantelung 98 durch epitaxiales Wachstum auf den Flanken des einkristallinen Wellenleiterstreifens 99 erzeugt. Der Temperprozeß wird so lange fortgeführt, bis die sich einkristallin ausbildende Ummantelung 98 die gewünschte Dicke erreicht hat. Die Ummantelung 98 weist einen gegenüber dem Brechungsindex $n_2$ des einkristallinen Wellenleiterstreifens 99 erniedrigten Brechungsindex $n_1$ auf; dies ist damit zu erklären, daß die amorphen Bereiche wegen verminderter Oberflächenbindungsenergien eine gewisse erhöhte Rückstäubung von Elementen mit besonders niedriger Zerstäubungsrate (z.B. Wismut) erfahren und daher etwas in der Zusammensetzung gegenüber der Zusammensetzung des Materials der einkristallinen Wellenleiterstreifen 99 abweichen. Diese Nachbehandlung durch Tempern kann alternativ auch erfolgen, nachdem auf der Eisengranatschicht 9 eine weitere dicke, amorphe Eisengranatschicht 11 (z.B. einer Dicke von 5 μm) abgeschieden worden ist, so daß sich auch oberhalb des Wellenleiterstreifens 99 ein einkristalliner Bereich ausbildet, dessen Brechungsindex ähnlich dem Brechungsindex $n_1$ der Schicht 5, aber kleiner als der Brechungsindex $n_2$ des Wellenleiterstreifens 99 ist. Dadurch, daß nur der Bereich der amorphen weiteren Eisengranatschicht 11 oberhalb des Wellenleiterstreifens 99 nach dem Temperprozeß in einkristalliner Ordnung vorliegt, können die übrigen Bereiche der weiteren Eisengranatschicht 11 oberhalb der Bereiche 97 der Eisengranatschicht 9 als Absorber wirken.

In Figur 7 ist ein weiterer Streifenwellenleiter dargestellt, wie er nach dem vorliegenden Verfahren hergestellt wurde.

Die Gitterstruktur einer nicht-magnetischen, in (110)-Richtung orientierten Gadolinium-Gallium-Granat-Einkristallscheibe 1 wurde mittels Ionenbeschuß in einem Argonplasma eines Drucks von 0,2 Pa bei einer Ionenenergie von einigen $10^2$ eV in Bereichen 7 bis in einige Atomlagen Tiefe gestört, wobei die durch Ionenbeschuß nicht zu störenden Bereiche der Einkristallscheibe durch eine Photolackschicht maskiert waren. Nach Entfernen der Photolackschicht wurden anschließend in einem nicht unterbrochenen Arbeitsgang die erste Eisengranatschicht 5 mittels Kathodenzerstäubung angebracht, die in den Bereichen 57 amorph oder polykristallin und im Bereich 59 einkristallin aufwächst. Die Verfahrensparameter zum Aufbringen der Eisengranatschicht 5 sind vorstehend zu den Figuren 4 bis 6 beschrieben. Anschließend werden die Eisengranatschicht 9 mit amorphen oder polykristallinen Bereichen 97 und dem den Wellenleiterstreifen 99 bildenden einkristallinen Bereich und die weitere Eisengranatschicht 11 mit amorphen oder polykristallinen Bereichen 117 und einem einkristallinen Bereich 119 wie vorstehend beschrieben, angebracht. Nach Abscheiden der weiteren Eisengranatschicht 11 wird eine amorphe Eisengranatschicht einer der Zusammensetzung des Wellenleiterstreifens 99 entsprechenden Zusammensetzung als Absorberschicht 13 abgeschieden, der ein gegenüber dem Brechungsindex $n_1$ der weiteren Eisengranatschicht 11 gleicher oder erhöhter Brechungsindex $n_3$ dadurch erteilt wurde, daß ein gegenüber den Bedingungen zur Abscheidung der weiteren Eisengranatschicht 11 geringerer Druck des Inertgasplasmas und eine niedrigere Substrattemperatur eingestellt wurden. Die amorphe Absorberschicht 13 wurde bei einem Druck von 0,2 Pa und einer Substrattemperatur von 250 °C abgeschieden.

Um eine semi-leaky-Struktur für einen halbabstrahlenden optischen Isolator zu erreichen, werden folgende Maßnahmen getroffen: Der Wellenleiterstreifen 99 wird epitaxial auf dem Bereich 59 der Eisengranatschicht 5 abgeschieden, um die für die Gesamtfunktion eines halbabstrahlenden optischen Isolators erforderliche optische Doppelbrechung dadurch einzustellen, daß die freien Gitterkonstanten a des Substrates 1 und des Schichtbereiches 59 verschieden von der freien Gitterkonstanten a des Wellenleiterstreifens 99 gewählt werden. Vorzugsweise soll die freie Gitterkonstante a des Wellenleiterstreifens 99 größer als die freie Gitterkonstante a des Substrates 1 sein. Andererseits soll mindestens ein benachbarter Bereich zum Wellenleiterstreifen 99, z.B. die Bereiche 97 oder der Bereich 119, gittermäßig entkoppelt vom Wellenleiterstreifen 99 sein, also nicht epitaxial abgeschieden sein, um in diesen Bereichen keine Doppelbrechung zu erzeugen. Dann ist an den Grenzflächen zwischen dem Wellenleiterstreifen 99 und den Bereichen 97 oder zwischen dem Wellenleiterstreifen 99 und dem Bereich 119 die Bedingung erfüllt, daß eine geführte Mode, z.B. die TM-Mode, in den Bereichen 97 und/oder dem Bereich 119 einen kleineren Brechungsindex vorfindet als im Wellenleiterstreifen 99, während die abstrahlende Mode, z.B. die TE-Mode, in den Bereichen 97 und/oder 119 einen größeren Brechungsindex vorfindet. Diese Bedingungen lassen sich einstellen, weil mit dem vorliegenden Verfahren gleichzeitig neben epitaxialen Bereichen Bereiche anderer Ordnung, z.B. amorpher oder polykristalliner Ordnung, erzeugt werden können.

## Patentansprüche

1. Verfahren zur Herstellung eines optischen Streifenwellenleiters für nicht-reziproke optische Bauelemente mit einem auf einem einkristallinen Granat-Substrat angebrachten einkristallinen Wellenleiterstreifen aus Eisengranat mit einem Brechungsindex $n_2$, der von Material eines niedrigeren Brechungsindex $n_1$ umgeben ist, dadurch gekennzeichnet, daß das Kristallgitter des Substrats örtlich in den Oberflächenbereichen (7), auf denen kein Wellenleiterstreifen aufwachsen soll, unter Ausbildung von Gitterfehlordnungen gestört wird und daß der Wellenleiterstreifen (99) und das ihn umgebende Material mittels HF-Kathodenzerstäubung (Sputterepitaxie) in einem Inertgasplasma unter Verwendung eines überwiegend eine Eisengranatphase enthaltenden Targets mit anderen Phasen nahezu gleicher Zerstäubungsrate auf dem Substrat abgeschieden wird, wobei die Kathodenzerstäubung in der Weise durchgeführt wird, daß nur in den ungestörten Oberflächenbereichen eine einkristalline Struktur erhalten wird.

2. Verfahren nach Anspruch 1, dadurch gekennzeichnet, daß als Substrat eine in (111)-Richtung orientierte nichtmagnetische Granat-Einkristallscheibe (1) eingesetzt wird.

3. Verfahren nach Anspruch 1, dadurch gekennzeichnet, daß als Substrat eine in (110)-Richtung orientierte nicht-magnetische Granat-Einkristallscheibe (1) eingesetzt wird.

4. Verfahren nach den Ansprüchen 2 oder 3, dadurch gekennzeichnet, daß als Substrat Calcium-Magnesium-Zirkonium-substituierter Gadolinium-Gallium-Granat $(Gd,Ca)_3(Ga,Mg,Zr)_5O_{12}$ eingesetzt wird.

5. Verfahren nach den Ansprüchen 2 oder 3, dadurch gekennzeichnet, daß auf der Granat-Einkristallscheibe (1) zunächst eine einkristalline Kobalt-substituierte Eisengranatschicht als Absorberschicht (3) angebracht wird.

6. Verfahren nach Anspruch 5, dadurch gekennzeichnet, daß die Absorberschicht (3) durch Flüssigphasenepitaxie angebracht wird.

7. Verfahren nach mindestens einem der Ansprüche 1 bis 6, dadurch gekennzeichnet, daß der einkristalline Wellenleiterstreifen (99) und ihn angebendes Material (5), (11), (97) eine Zusammensetzung gemäß der allgemeinen Formel $(A,B)_3(A,B)_5O_{12}$ hat mit A = mindestens ein Seltenerdmetall, Bi,Pb und/oder Ca B = Ga,Al,Fe,Co,Ni,Mn,Ru,Ir,In und/oder Sc.

8. Verfahren nach Anspruch 7, dadurch gekennzeichnet, daß der einkristalline Wellenleiterstreifen (99) und das ihn umgebende Material (5), (11), (97) eine Zusammensetzung hat gemäß der Formel $Gd_{1,90}Bi_{1,45}Fe_{4,09}Al_{0,34}Ga_{0,22}O_{12}$.

9. Verfahren nach Anspruch 7, dadurch gekennzeichnet, daß der einkristalline Wellenleiterstreifen (99) und das ihn umgebende Material (5), (11), (97) eine Zusammensetzung hat gemäß der Formel $Gd_{1,97}Bi_{1,04}Fe_{4,51}Ga_{0,22}Al_{0,26}O_{12}$.

10. Verfahren nach mindestens einem der Ansprüche 1 bis 9, dadurch gekennzeichnet, daß der einkristalline Wellenleiterstreifen (99) und das ihn umgebende Material (5), (11), (97) in einem Inertgasplasma eines Drucks von 0,2 bis 2,0 Pa bei einer Ionenenergie der die anwachsende Schicht bombardierenden Teilchen von etwa 10 bis $10^2$ eV abgeschieden wird.

11. Verfahren nach mindestens einem der Ansprüche 1 bis 10, dadurch gekennzeichnet, daß das den Wellenleiterstreifen (99) seitlich umgebende Material (97) amorph ist.

12. Verfahren nach mindestens einem der Ansprüche 1 bis 10, dadurch gekennzeichnet, daß das den wellenleiterstreifen (99) seitlich umgebende Material (97) polykristallin ist.

13. Verfahren nach Anspruch 11, dadurch gekennzeichnet, daß das Substrat während Hoch frequenz-Kathoden Zerstänbung auf eine Temperatur aufgeheizt wird, die höher ist, als die Temperatur, bei der epitaxiales Wachstum auf Substratbereichen mit ungestörtem Kristallgitter beginnt, und die niedriger ist, als die Temperatur, bei der polykristallines Wachstum auf Substratbereichen mit gestörtem Kristallgitter (7) einsetzt.

14. Verfahren nach Anspruch 13, dadurch gekennzeichnet, daß das Substrat auf eine Temperatur im Bereich von 450 bis 520 °C aufgeheizt wird.

15. Verfahren nach Anspruch 12, dadurch gekennzeichnet, daß das Substrat auf eine Temperatur aufgeheizt wird, die höher ist, als die Temperatur, bei der polykristallines Wachstum auf Substratbereichen mit gestörtem Kristallgitter (7) einsetzt.

16. Verfahren nach Anspruch 15, dadurch gekennzeichnet, daß das Substrat auf eine Temperatur > 520 °C aufgeheizt wird.

17. Verfahren nach mindestens einem der Ansprüche 1 bis 16, dadurch gekennzeichnet, daß vor Abscheiden des den Wellenleiterstreifen (99) bildenden Materials aus demselben Material zunächst eine erste einkristalline Eisengranatschicht (5) mittels HF-Kathodenzerstäubung abgeschieden wird, der ein gegenüber dem Brechungsindex $n_2$ des Wellenleiterstreifens erniedrigter Brechungsindex $n_1$ dadurch erteilt wird, daß entweder eine gegenüber den Bedingungen zur Abscheidung des einkristallinen Wellenleiterstreifens größere HF-Spannung an der Targetelektrode und/oder ein höherer Druck des Inertgasplasmas und/oder eine höhere Substrattemperatur und/oder eine an die Substratelektrode angelegte HF-Spannung (Substrat-bias) eingestellt wird(werden).

18. Verfahren nach mindestens einem der Ansprüche 1 bis 17, dadurch gekennzeichnet, daß nach Abscheiden des den Wellenleiterstreifen (99) bildenden Materials aus demselben Material eine weitere Eisengranatschicht (11) mittels HF-Kathodenzerstäubung abgeschieden wird, die auf dem Wellenleiterstreifen einkristallin und auf dem ihn seitlich umgebenden Material amorph oder polykristallin aufwächst und der ein gegenüber dem Brechungsindex $n_2$ des Wellenleiterstreifens erniedrigter Brechungsindex $n_1$ dadurch erteilt wird, daß entweder eine gegenüber den Bedingungen zur Abscheidung des einkristallinen Wellenleiterstreifens größere HF-Spannung an der Targetelektrode und/oder ein höherer Druck des Inertgasplasmas und/oder eine höhere Substrattemperatur und/oder eine an die Substratelektrode angelegte HF-Spannung (Substrat-bias) eingestellt wird(werden).

19. Verfahren nach mindestens einem der Ansprüche 1 bis 11 und 13 bis 18, dadurch gekennzeichnet, daß das den Wellenleiterstreifen (99) seitlich umgebende Material (97) in einem nachfolgenden Ätzschritt entfernt wird und mittels HF-Kathodenzerstäubung eine weitere einkristalline Eisengranatschicht (11) aus dem den Wellenleiterstreifen bildenden Material neben und auf dem Wellenleiterstreifen abgeschieden wird, der ein gegenüber dem Brechungsindex $n_2$ des Wellenleiterstreifens erniedrigter Brechungsindex $n_1$ dadurch erteilt wird, daß entweder eine gegenüber den Bedingungen zur Abscheidung des einkristallinen Wellenleiterstreifens größere HF-Spannung an der Targetelektrode und/oder ein höherer Druck des Inertgasplasmas und/oder eine höhere Substrattemperatur und/oder eine an die Substratelektrode angelegte HF-Spannung (Substrat-bias) eingestellt wird(werden).

20. Verfahren nach den Ansprüchen 18 oder 19, dadurch gekennzeichnet, daß die weitere Eisengranatschicht (11) in einem Inertgasplasma eines Drucks im Bereich von 0,2 bis 2,0 Pa bei einer Ionenenergie der die anwachsende Schicht bombardierenden Teilchen von etwa 10 bis $10^2$ eV abgeschieden wird.

21. Verfahren nach den Ansprüchen 10 oder 19, daß auf der weiteren Eisengranatschicht (11) mittels HF-Kathodenzerstäubung eine amorphe Eisengranatschicht einer der Zusammensetzung des Wellenleiterstreifens (99) entsprechenden Zusammensetzung als Absorberschicht (13) abgeschieden wird, der ein gegenüber dem Brechungsindex $n_1$ der weiteren Eisengranatschicht gleicher oder erhöhter Brechungsindex $n_3$ dadurch erteilt wird, daß ein gegenüber den Bedingungen zur Abscheidung der weiteren Eisengranatschicht geringerer Druck des Inertgasplasmas und/oder eine niedrigere Substrattemperatur eingestellt wird(werden).

22. Verfahren nach Anspruch 21, dadurch gekennzeichnet, daß die amorphe Absorberschicht (13) in einem Inertgasplasma eines Drucks im Bereich von 0,1 bis 1,0 Pa abgeschieden wird.

23. Verfahren nach Anspruch 21, dadurch gekennzeichnet, daß die amorphe Absorberschicht (13) bei einer Substrattemperatur im Bereich von 200 bis 450 °C abgeschieden wird.

24. Verfahren nach mindestens einem der Ansprüche 1 bis 23, dadurch gekennzeichnet, daß das HF-Kathodenzerstäubungsverfahren in einem Edelgasplasma durchgeführt wird.

25. Verfahren nach mindestens einem der Ansprüche 1 bis 24, dadurch gekennzeichnet, daß als Targetelektrode ein Magnetron, in das die für den Zerstäubungsprozeß erforderliche HF-Leistung eingespeist wird, eingesetzt wird.

26. Verfahren nach mindestens einem der Ansprüche 1 bis 11,13,14,17,18,20,24 oder 25, dadurch gekennzeichnet, daß das System aus Substrat, einkristallinem Wellenleiterstreifen (99) und ihn umgebendema morphem Material (97) einem Temperprozeß unterzogen wird bei einer Temperatur, bei der laterales epitaxiales Wachstum von den Flanken des Wellenleiterstreifens in das ihn umgebende amorphe Material erfolgt, derart, daß seitlich zum Wellenleiterstreifen eine einkristalline Ummantelung (98) von einigen um Dicke entsteht.

27. Verfahren nach Anspruch 26, dadurch gekennzeichnet, daß der Temperprozeß innerhalb eines Temperaturbereiches von etwa 50 K unterhalb der Kristallisationstemperatur des amorphen Materials durchgeführt wird.

28. Verfahren nach mindestens einem der Ansprüche 1 bis 5 oder 17, dadurch gekennzeichnet, daß die Gitterstruktur des Substrats in Form einer Granat-Einkristallscheibe (1) oder die Gitterstruktur der auf einer ungestörten Granat-Einkristallscheibe angebrachten einkristallinen Absorberschicht (3) oder die Gitterstruktur der auf einer ungestörten einkristallinen Absorberschicht angebrachten ersten einkristallinen Eisengranatschicht (5) bis in einige Atomlagen Tiefe durch Ionenbeschuß aus einem Inertgas-Plasma in Bereichen (7), auf denen kein Wellenleiterstreifen epitaktisch aufwachsen soll, gestört wird.

29. Verfahren nach Anspruch 28, <u>dadurch gekennzeichnet,</u> daß die durch Ionenbeschuß nicht zu störenden Bereiche (7) mit einer Photolackmaske abgedeckt werden und der Ionenbeschuß anschließend in einem Edelgasplasma eines Drucks von 0,1 bis 1 Pa bei einer Ionenenergie 30 eV über eine Dauer von einigen Minuten durchgeführt wird.

30. Verfahren nach Anspruch 29, <u>dadurch gekennzeichnet,</u> daß der Ionenbeschuß in einem Argon-Plasma eines Drucks von 0,2 Pa bei einer Ionenenergie von einigen $10^2$ eV durchgeführt wird.

31. Verwendung des nach dem Verfahren gemäß den Ansprüchen 1 bis 30 hergestellten Streifenwellenleiters als halbabstrahlender optischer Isolator.

## Claims

1. A method of manufacturing an optical stripline waveguide for non-reciprocal optical components, which stripline waveguide comprises on a monocrystalline garnet substrate an iron garnet monocrystalline waveguide strip having a refractive index $n_2$, which is surrounded by material with a lower refractive index $n_1$, characterized in that the crystal lattice of the substrate is locally disturbed in the surface regions (7) on which no waveguide strip should grow, thereby forming a lattice disorder, and in that the waveguide strip (99) and the material surrounding it are deposited on the substrate by means of RF-cathode sputtering (sputter epitaxy) in an inert gas plasma, making use of a target which contains mainly an iron garnet phase together with other phases with an almost equal sputtering rate, the cathode sputtering operation being carried out so that a monocrystalline structure is obtained only in the undisturbed surface regions.

2. A method as claimed in Claim 1, characterized in that a (111)-oriented non-magnetic garnet single crystal disc (1) is used as a substrate.

3. A method as claimed in Claim 1, characterized in that a (110)-oriented non-magnetic garnet single crystal disc (1) is used as a substrate.

4. A method as claimed in Claim 2 or 3, characterized in that calcium magnesium zirconium-substituted gadolinium gallium garnet $(Gd,Ca)_3(Ga,Mg,Zr)_5O_{12}$ is used as a substrate.

5. A method as claimed in Claim 2 or 3, characterized in that a monocrystalline cobalt-substituted iron garnet layer is first provided on the garnet single crystal disc (1) as an absorbing layer (3).

6. A method as claimed in Claim 5, characterized in that the absorbing layer (3) is provided by means of liquid phase epitaxy.

7. A method as claimed in at least one of the Claims 1 to 6, characterized in that the monocrystalline waveguide strip (99) and the material surrounding it (5), (11), (97) have a composition according to the general formula $(A,B)_3(A,B)_5O_{12}$, where A = at least one rare earth metal, Bi, Pb and/or Ca B = Ga, Al, Fe, Co, Ni, Mn, Ru, Ir, In and/or Sc.

8. A method as claimed in Claim 7, characterized in that the monocrystalline waveguide strip (99) and the material surrounding it (5), (11), (97) have a composition according to the formula $Gd_{1,90}Bi_{1,45}Fe_{4,09}Al_{0,34}Ga_{0,22}O_{12}$.

9. A method as claimed in Claim 7, characterized in that the monocrystalline waveguide strip (99) and the material surrounding it (5), (11), (97) have a composition according to the formula $Gd_{1,97}Bi_{1,04}Fe_{4,51}Ga_{0,22}Al_{0,26}O_{12}$.

10. A method as claimed in at least one of the Claims 1 to 9, characterized in that the monocrystalline waveguide strip (99) and the material surrounding it (5), (11), (97) are deposited in an inert gas plasma having a pressure from 0.2 to 2.0 Pa at an ion energy of the particles which bombard the growing layer of approximately 10 to $10^2$ eV.

11. A method as claimed in at least one of the Claims 1 to 10, characterized in that the material (97) which laterally surrounds the waveguide strip (99) is amorphous.

12. A method as claimed in at least one of the Claims 1 to 10, characterized in that the material (97) which laterally surrounds the waveguide strip (99) is polycrystalline.

13. A method as claimed in Claim 11, characterized in that during RF-cathode sputtering the substrate is heated to a temperature which is higher than the temperature at which epitaxial growth starts on substrate regions having an undisturbed crystal lattice, and lower than the temperature at which polycrystalline growth starts on substrate regions having a disturbed crystal lattice (7).

14. A method as claimed in Claim 13, characterized in that the substrate is heated to a temperature in the range from 450 to 520°C.

15. A method as claimed in Claim 12, characterized in that the substrate is heated to a temperature which is higher than the temperature at which polycrystalline growth starts on substrate regions having a disturbed crystal lattice (7).

16. A method as claimed in Claim 15, characterized in that the substrate is heated to a temperature > 520°C.

17. A method as claimed in at least one of the Claims 1 to 16, characterized in that the deposition of the material forming the waveguide strip (99) is preceded by the deposition of a first monocrystalline iron garnet layer (5) of the same material by means of RF cathode sputtering, which layer is provided with a refractive index $n_1$ which is lower than the refractive index $n_2$ of the waveguide strip because in comparison with the conditions under which the monocrystalline waveguide strip is deposited a higher RF voltage is applied to the target electrode and/or the pressure of the inert gas plasma is increased and/or the substrate temperature is raised and/or an RF voltage (substrate bias) is applied to the substrate electrode.

18. A method as claimed in at least one of the Claims 1 to 17, characterized in that the deposition of the material forming the waveguide strip (99) is followed by the deposition of a further iron garnet layer (11) of the same material by means of RF cathode sputtering, which layer grows in a monocrystalline manner on the waveguide strip and in an amorphous or polycrystalline manner on the material which laterally surrounds this waveguide strip, and to which a refractive index $n_1$ is imparted which is lower than the refractive index $n_2$ of the waveguide strip, because in comparison with the conditions under which the monocrystalline waveguide strip is deposited a higher RF voltage is applied to the target electrode and/or the pressure of the inert gas plasma is increased and/or the substrate temperature is raised and/or an RF voltage (substrate bias) is applied to the substrate electrode.

19. A method as claimed in at least one of the Claims 1 to 11 and 13 to 18, characterized in that the material (97) which laterally surrounds the waveguide strip (99) is removed in a subsequent etching step, and by means of RF-cathode sputtering a further monocrystalline iron garnet layer (11) of the material forming the waveguide strip is deposited next to and on the waveguide strip, which layer obtains a refractive index $n_1$ which is lower than the refractive index $n_2$ of the waveguide strip because in comparison with the conditions under which the monocrystalline waveguide strip is deposited a higher RF voltage is applied to the target electrode and/or the pressure of the inert gas plasma is increased and/or the substrate temperature is raised and/or an RF voltage (substrate bias) is applied to the substrate electrode.

20. A method as claimed in Claim 18 or 19, characterized in that the further iron garnet layer (11) is deposited in an inert gas plasma having a pressure in the range from 0.2 to 2.0 Pa, the ion energy of the particles which bombard the growing layer ranging from approximately 10 to $10^2$ eV.

21. A method as claimed in Claim 18 or 19, characterized in that an amorphous iron garnet layer having a composition which corresponds to that of the waveguide strip (99) is deposited as an absorbing layer (13) on the further iron garnet layer (11) by means of RF-cathode sputtering, to which amorphous iron garnet layer a refractive index $n_3$ is imparted which is the same or higher than the refractive index $n_1$ of the further iron garnet layer, because in comparison with the conditions under which the further iron garnet layer is deposited the pressure of the inert gas plasma is reduced and/or the substrate temperature is lowered.

22. A method as claimed in Claim 21, characterized in that the amorphous absorbing layer (13) is deposited in an inert gas plasma having a pressure in the range from 0. 1 to 1.0 Pa.

23. A method as claimed in Claim 21, characterized in that the amorphous absorbing layer (13) is deposited at a substrate temperature in the range from 200 to 450°C.

24. A method as claimed in at least one of the Claims 1 to 23, characterized in that the RF-cathode sputtering process is carried out in a helium-group gas plasma.

25. A method as claimed in at least one of the Claims 1 to 24, characterized in that a magnetron is used as a target electrode, to which the RF power necessary for the sputtering process is applied.

26. A method as claimed in at least one of the Claims 1 to 11, 13, 14, 17, 18, 20, 24 or 25, characterized in that the system comprising the substrate, the monocrystalline waveguide strip (99) and the amorphous material (97) surrounding the latter is subjected to a tempering process at a temperature at which lateral epitaxial growth takes place from the sides of the waveguide strip to the amorphous material surrounding it, such that along the sides of the waveguide strip a monocrystalline cladding (98) having a thickness of several μm is formed

27. A method as claimed in Claim 26, characterized in that the tempering process is carried out within a temperature range of about 50 k below the crystallization temperature of the amorphous material.

28. A method as claimed in at least one of the Claims 1 to 5 or 17, characterized in that the lattice structure of the substrate in the form of a garnet single crystal disc (1) or the lattice structure of a monocrystalline absorbing layer (3) which is provided on an undisturbed garnet single crystal disc or the lattice structure of a first monocrystalline iron garnet layer (5) which is provided on an undisturbed monocrystalline absorbing layer is disturbed by ion bombardment from an inert gas plasma to a depth of several atom layers in regions (7) where no waveguide strip should grow epitaxially.

29. A method as claimed in Claim 28, characterized in that the regions (7) which are not to be disturbed by ion bombardment are covered with a photoresist mask, after which the ion bombardment is carried out in a helium-group gas plasma at a pressure of 0.1 to 1 Pa and an ion energy > 30 eV for several minutes.

30. A method as claimed in Claim 29,c haracterized in that the ion bombardment is carried in an argon plasma at a pressure of 0.2 Pa and an ion energy of some $10^2$ eV.

31. The use of the stripline waveguide manufactured in accordance with the method as claimed in the Claims 1 - 30, as a semi-leaky optical isolator.


## Revendications

1. Procédé pour la fabrication d'un guide d'ondes optique en forme de bande pour des composants optiques non réciproques comportant une bande de guide d'ondes monocristalline appliquée sur un substrat de grenat monocristallin et constituée par du grenat de fer présentant un indice de réfraction $n_2$ qui est entourée de matériau d'un indice de réfraction $n_1$, caractérisé en ce que dans les zones superficielles (7) où des bandes de guides d'ondes ne doivent pas se former, le réseau cristallin du substrat est localement perturbé avec formation d'imperfections de réseau et que la bande de guides d'ondes (99) et le matériau qui l'entoure sont déposés par perturbation cathodique HF (épitaxie de pulvérisation) dans un plasma de gaz inerte à l'aide d'une cible contenant essentiellement une phase de grenat de fer avec d'autres phases présentant pratiquement les mêmes coefficients de pulvérisation sur un substrat, la pulvérisation cathodique étant effectuée de façon qu'une structure monocristalline ne s'obtienne que dans les zones superficielles non perturbées.

2. Procédé selon la revendication 1, caractérisé en ce que comme substrat on utilise un disque monocristallin de grenat non magnétique (1) qui est orienté dans la direction (111).

3. Procédé selon la revendication 1, caractérisé en ce que comme substrat, on utilise un disque monocristallin de grenat non magnétique (1) qui est orienté dans la direction ( 110).

4. Procédé selon la revendication 2 ou 3, caractérisé en ce que comme substrat on utilise du grenat de gallium-gadolinium substitué par du calcium-magnésium-zirconium (Gd, Ca)$_3$(Ga, Mg, Zr)$_5$O$_{12}$.

5. Procédé selon la revendication 2 ou 3, caractérisé en ce que sur le disque monocristallin en grenat (1) est d'abord appliquée une couche de grenat de fer monocristalline substituée par du cobalt comme couche d'absorption (3).

6. Procédé selon la revendication 5, caractérisé en ce que la couche d'absorption (3) est appliquée par épitaxie en phase liquide.

7. Procédé selon au moins l'une des revendications 1 à 6, caractérisé en ce que la bande de guide d'ondes monocristalline (99) et le matériau (5), (11), (97) qui l'entoure présentent une composition répondant à la formule générale (A,B)$_3$(A,B)$_5$O$_{12}$ A étant au moins un métal des terres rares, Bi, Pb et/ou Ca B étant Ga, Al, Fe, Co, Ni, Mn, Ru, Ir, In et/ou Sc.

8. Procédé selon la revendication 7, caractérisé en ce que la bande de guide d'ondes monocristalline (99) et le matériau (5), (11), (97) qui l'entoure présentent une composition répondant à la formule $Gd_{1,90}Bi_{1,45}Fe_{4,09}Al_{0,34}Ga_{0,22}O_{12}$.

9. Procédé selon la revendication 7, caractérisé en ce que la bande de guides d'ondes monocristalline (99) et le matériau (5), (11), (97) qui l'entoure présentent une composition répondant à la formule $Gd_{1,97}Bi_{1,04}Fe_{4,51}Ga_{0,22}Al_{0,26}O_{12}$.

10. Procédé selon au moins l'une des revendications 1 à 9, caractérisé en ce que la bande de guide d'ondes (99) et le matériau (5), (11), (97) qui l'entoure sont déposés dans un plasma de gaz inerte sous une pression de 0,2 à 2,0 Pa à une énergie ionique des particules bombardant la couche en croissance d'environ 10 à $10^2$ eV.

11. Procédé selon au moins l'une des revendications 1 à 10, caractérisé en ce que le matériau (97) entourant latéralement la bande de guide d'ondes (99) est amorphe.

12. Procédé selon au moins l'une des revendications 1 à 10, caractérisé en ce que le matériau (97) entourant latéralement la bande de guide d'ondes (99) est polycristallin.

13. Procédé selon la revendication 11, caractérisé en ce que lors de la pulvérisation cathodique à haute fréquence, le substrat est chauffé à une température qui est supérieure à laquelle commence la croissance épitaxiale dans des zones de substrat présentant un réseau cristallin non perturbé et qui est inférieure à la température à laquelle commence la croissance polycristalline dans des zones de substrat présentant un réseau cristallin perturbé (7).

14. Procédé selon la revendication 13, caractérisé en ce que le substrat est chauffé à une température située dans la gamme comprise entre 450 et 520°C.

EP 0 252 536 B1

15. Procédé selon la revendication 12, caractérisé en ce que le substrat est chauffé à une température qui est supérieure à la température à laquelle commence la croissance polycristalline dans des zones de substrat présentant un réseau cristallin perturbé (7).

16. Procédé selon la revendication 15, caractérisé en ce que le substrat est chauffé à une température inférieure à 520°.

17. Procédé selon au moins l'une des revendications 1 à 16, caractérisé en ce qu'avant le dépôt du matériau formant la bande de guide d'ondes (99) est déposée d'abord une première couche de grenat de fer monocristalline (5) du même matériau par pulvérisation cathodique HF à laquelle est conféré un indice de réfraction $n_1$ inférieur à l'indice de réfraction $n_2$ de la bande de guides d'ondes de façon qu'il s'établisse, comparativement aux conditions pour le dépôt de la bande de guide d'ondes monocristalline, une tension HF plus élevée à l'électrode de cible et/ou une pression plus élevée du plasma de gaz inerte et/ou une température de substrat plus élevée et/ou une tension HF (polarisation de substrat) appliquée à l'électrode de substrat.

18. Procédé selon au moins l'une des revendications 1 à 17, caractérisé en ce qu'après le dépôt du matériau formant la bande de guide d'ondes (99), une autre couche de grenat de fer (11) du même matériau est déposée par pulvérisation cathodique HF, laquelle couche est formée par croissance sur la bande de guide d'ondes de façon monocristalline et sur le matériau qui l'entoure latéralement de façon amorphe ou polycristalline et à laquelle est conféré un indice de réfraction $n_1$ inférieur à l'indice de réfraction $n_2$ de la bande de guide d'ondes de façon qu'il s'établisse, comparativement aux conditions pour le dépôt d'une bande de guide d'ondes monocristalline, une tension HF supérieure à l'électrode de cible et/ou une pression plus élevée du plasma de gaz inerte et/ou une température de substrat plus élevée et/ou une tension HF appliquée à l'électrode de substrat (polarisation de substrat).

19. Procédé selon au moins l'une des revendications 1 à 11, et 13 à 18, caractérisé en ce que le matériau (99) entourant latéralement la bande de guide d'ondes (97) est enlevé dans une étape de décapage suivante et une autre couche de grenat de fer monocristalline (11) du matériau formant la bande de guide d'ondes est déposée par pulvérisation cathodique HF à côté de la bande de guide d'ondes et sur cette dernière, couche à laquelle est conféré un indice de réfraction $n_1$ inférieur à l'indice de réfraction $n_2$ de la bande de guide d'ondes de façon qu'il s'établisse, comparativement aux conditions pour le dépôt de la bande de guide d'ondes monocristalline, une tension HF supérieure à l'électrode de cible et/ou une pression plus élevée du plasma de gaz inerte et/ou une température de substrat plus élevée et/ou une tension HF appliquée à l'électrode de substrat (polarisation du substrat).

20. Procédé selon la revendication 18 ou 19, caractérisé en ce que l'autre couche de grenat de fer (11) est déposée dans un plasma de gaz inerte d'une pression située dans la gamme comprise entre 0,2 à 2,0 Pa à une énergie ionique des particules bombardant la couche en croissance d'environ 10 à $10^2$ eV.

21. Procédé selon les revendications 18 ou 19, caractérisé en ce que sur l'autre couche de grenat de fer (11) est déposée par pulvérisation cathodique HF une couche de grenat de fer amorphe d'une composition correspondant à la composition de la bande de guide d'ondes (99) comme couche d'absorption (13) à laquelle est conféré un indice de réfraction $n_3$ égal ou supérieur à l'indice de réfraction $n_1$ de l'autre couche de grenat de fer de façon qu'il s'établisse, comparativement aux conditions pour le débit de l'autre couche de grenat, une pression plus faible du plasma de gaz inerte et/ou une température de substrat plus basse.

22. Procédé selon la revendication 21, caractérisé en ce que la couche d'absorption amorphe (13) est déposée dans un plasma de gaz inerte d'une pression située dans la gamme comprise entre 0,1 à 1,0 Pa.

23. Procédé selon la revendication 21, caractérisé en ce que la couche d'absorption amorphe (13) est déposée à une température de substrat située dans la gamme comprise entre 200 et 450°C.

24. Procédé selon au moins l'une des revendications 1 à 23, caractérisé en ce que le procédé de pulvérisation cathodique HF s'effectue dans un plasma de gaz rare.

25. Procédé selon au moins l'une des revendications 1 à 24, caractérisé en ce que comme électrode de cible, on utilise un magnétron alimenté en puissance HF nécessaire pour le processus de pulvérisation.

26. Procédé selon au moins l'une des revendications 1 à 11, 13, 14, 17, 18, 20, 24 ou 25, caractérisé en ce que le système comprenant le substrat, la bande de guide d'ondes monocristalline (99) et le matériau amorphe (97) qui l'entoure est soumis à un processus de recuit à une température à laquelle s'effectue la croissance épitaxiale latérale des flancs de la bande de guide d'ondes dans le matériau amorphe qui l'entoure de façon qu'un enrobage monocristallin (98) d'une épaisseur de quelques μm se forme à côté des bandes de guides d'ondes.

27. Procédé selon la revendication 26, caractérisé en ce que le processus de recuit s'effectue dans une gamme de températures d'environ 50 K au-dessous de la température de cristallisation du matériau amorphe.

28. Procédé selon au moins l'une des revendications 1 à 5 ou 17, caractérisé en ce que la structure de réseau du substrat sous forme d'un disque monocristallin de grenat (1) ou la structure de réseau de la couche d'absorption monocristalline (3) appliquée sur un disque monocristallin de grenat non perturbé ou la structure

16

de réseau de la première couche de grenat de fer monocristalline (5) appliquée sur une couche d'absorption monocristalline non perturbée est perturbée jusqu'à une profondeur de quelques couches d'atomes par bombardement ionique à partir d'un plasma de gaz inerte dans des zones (7) sur lesquelles une bande de guides d'ondes ne doit pas se former par voie épitaxiale.

29. Procédé selon la revendication 28, caractérisé en ce que les zones (7) qui ne doivent pas être perturbées par bombardement ionique sont recouvertes d'un masque en vernis photosensible et que le bombardement ionique s'effectue ensuite dans un plasma de gaz rare d'une pression de 0,1 à 1 Pa à une énergie ionique de 30 eV pendant une durée de quelques minutes.

30. Procédé selon la revendication 29, caractérisé en ce que le bombardement ionique s'effectue dans un plasma d'argon d'une pression de 0,2 Pa à une énergie ionique de quelques $10^2$ eV.

31. Application de la bande de guide d'ondes réalisée conformément au procédé selon la revendication 1 à 30 comme isolateur optique semi-rayonnant.

WL

(n3)

(n2)

S

(n1)

**FIG.1a**

WL

(n2)

S

(n1)

**FIG.1b**

WL

(n2)

(n1)

S

**FIG.1c**

FIG. 2

FIG. 3

FIG. 4

FIG. 5

FIG. 6

FIG. 7